(19) Europäisches Patentamt
European Patent Office
Office européen des brevets

(11) **EP 4 585 756 A1**

(12) **EUROPEAN PATENT APPLICATION**
published in accordance with Art. 153(4) EPC

(43) Date of publication:
**16.07.2025 Bulletin 2025/29**

(21) Application number: **23862857.2**

(22) Date of filing: **07.08.2023**

(51) International Patent Classification (IPC):
*E02F 9/26* *(2006.01)* *E02F 3/43* *(2006.01)*

(52) Cooperative Patent Classification (CPC):
**E02F 3/43; E02F 9/26**

(86) International application number:
**PCT/JP2023/028819**

(87) International publication number:
**WO 2024/053315 (14.03.2024 Gazette 2024/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.09.2022 JP 2022143338**

(71) Applicant: **Hitachi Construction Machinery Co.,
Ltd.
Tokyo 110-0015 (JP)**

(72) Inventors:
• **HAYAKAWA, Naoki
Tsuchiura-shi, Ibaraki 300-0013 (JP)**
• **IZUMI, Shiho
Tsuchiura-shi, Ibaraki 300-0013 (JP)**

(74) Representative: **MERH-IP Matias Erny Reichl
Hoffmann
Patentanwälte PartG mbB
Paul-Heyse-Straße 29
80336 München (DE)**

(54) **CONSTRUCTION HISTORY CALCULATION SYSTEM AND LANDFORM DATA GENERATION
SYSTEM**

(57) The construction history calculation system includes a controller that calculates construction history data based on the detection results of a posture detection device that detects the posture of a work machine. The controller acquires target surface data and, based on the acquired target surface data, sets multiple configuration surfaces, including the target configuration surface and adjacent configuration surfaces that constitute the target surface data, as surface areas. It sets multiple record points to achieve a predetermined point density for the surface areas, calculates the trajectory of the work machine's working device based on the detection results of the posture detection device, and calculates the position information of the working device's trajectory, associating the position information of the monitor points of the working device that constitute the trajectory with each of the multiple record points, as construction history data.

[FIG. 16]

## Description

Technical Field

The present invention relates to a construction history calculation system and a terrain data generation system.

Background Art

Work machines such as hydraulic excavators equipped with machine control functions and machine guidance functions are known. The machine control function is a function that controls the operation of the boom, arm, and bucket so that the bucket moves along a target surface created with 3D CAD software or the like. The machine guidance function is a function that presents information on the posture of the work machine and the positional relationship between the target surface around the work machine and the components of the work machine (such as the bucket) to the operator.

In recent years, there has been a growing trend to utilize construction history data, which records the 3D position information of work machines calculated to demonstrate machine control and guidance functions, along with time information. For example, terrain data may be generated based on construction history data, and the generated terrain data may be used to manage the work volume of work machines.

Patent Document 1 discloses the following work support management system. The excavation support database is provided with a display table and a display content table. The display table stores the state of the work area for each mesh, and the display content table stores the identification display method (display color) corresponding to the state of each mesh. The work support management system of the work machine reads the display color of the display content table corresponding to the state (height) of each mesh in the display table and displays the state of the work area in different colors.

Prior Art Documents

Patent Document

Patent Document 1: JP 2005-11058 A

Summary of the Invention

Problems to be Solved by the Invention

In the system described in Patent Document 1, the work area is represented as a mesh representing a plane of a predetermined size (a square mesh with a side of 50 cm) as a unit, and display processing and detailed data calculation are performed for each mesh. However, since the meshes are set at equal intervals, depending on the position of the origin of the mesh and the spacing of the mesh, there is a risk that geographical features such as characteristic parts like the shoulder or toe of a slope in a slope area cannot be accurately reproduced. In other words, the system described in Patent Document 1 may not be able to generate highly accurate terrain data.

The present invention aims to provide a construction history calculation system and a terrain data generation system capable of calculating construction history data necessary for generating highly accurate terrain data.

Means for Solving the Problem

A construction history calculation system according to one aspect of the present invention includes a controller that calculates construction history data based on detection results of a posture detection device that detects a posture of a work machine. The controller acquires target surface data and sets a plurality of configuration surfaces, including a target configuration surface that composes the target surface data and an adjacent configuration surface adjacent to the target configuration surface, in a surface area based on the acquired target surface data, the controller sets a plurality of recording points to achieve a predetermined point density for the surface area and calculates a trajectory of a working device of the work machine based on the detection results of the posture detection device, the controller calculates position information of the trajectory of the working device, which associates position information of monitor points of the working device that compose the trajectory of the working device with each of the plurality of recording points, as the construction history data.

Advantages of the Invention

According to the present invention, it is possible to provide a construction history calculation system and a terrain data generation system capable of calculating construction history data necessary for generating highly accurate terrain data.

Brief Description of the Drawings

[FIG. 1] FIG. 1 is a diagram showing the configuration of a management system for a work machine.
[FIG. 2] FIG. 2 is a configuration diagram of a hydraulic excavator.
[FIG. 3] FIG. 3 is a diagram showing the configuration of a hydraulic drive device of a hydraulic excavator.
[FIG. 4] FIG. 4 is a hardware configuration diagram of a terrain data generation system.
[FIG. 5] FIG. 5 is a functional block diagram showing the main functions of the terrain data generation system.
[FIG. 6] FIG. 6 is a diagram showing the shovel reference coordinate system.
[FIG. 7] FIG. 7 is a plan schematic diagram of the target shape.
[FIG. 8] FIG. 8 is a perspective view of the target shape.
[FIG. 9] FIG. 9 is a development view of the target shape, showing an example of the arrangement of recording points according to the present embodiment.
[FIG. 10] FIG. 10 is a perspective view of the target shape, showing an example of the arrangement of recording points according to the present embodiment.
[FIG. 11] FIG. 11 is a diagram showing an example of target surface data in which the surface on the same plane is finely divided.
[FIG. 12A] FIG. 12A is a diagram showing an example in which recording points are arranged at a predetermined point density for each configuration surface.
[FIG. 12B] FIG. 12B is a diagram showing an example in which recording points are arranged at a predetermined point density in a surface area formed by multiple configuration surfaces.
[FIG. 13] FIG. 13 is a flowchart showing the flow of the surface area setting process by the recording point setting section.
[FIG. 14] FIG. 14 is a perspective view of the target shape, showing an example in which the target shape is divided into four parts.
[FIG. 15A] FIG. 15A is a diagram showing an example in which recording points are arranged on the outer periphery of the surface area.
[FIG. 15B] FIG. 15B is a diagram showing an example in which recording points are arranged at the endpoints of the outer boundary line of the surface area.
[FIG. 16] FIG. 16 is a flowchart showing the flow of the recording point setting process by the recording point setting section.
[FIG. 17] FIG. 17 is a diagram explaining the recording points and the direction vectors set for the recording points.
[FIG. 18] FIG. 18 is a diagram showing the progress of construction toward the vertical wall surface constituting the target shape.
[FIG. 19] FIG. 19 is a diagram explaining the direction vectors of the recording points set at the corners of the target shape.
[FIG. 20] FIG. 20 is a diagram showing an example of a construction history data table, which includes recording point coordinates, trajectory coordinates, and operation determination results.
[FIG. 21] FIG. 21 is a diagram explaining the method of recording the trajectory coordinates of the bucket.
[FIG. 22] FIG. 22 is a diagram showing an example of a construction history data table, which includes recording point coordinates, direction vectors, operation determination results, and target surface distance.
[FIG. 23] FIG. 23 is a flowchart showing the flow of the construction history data generation process executed by the vehicle body controller.
[FIG. 24] FIG. 24 is a diagram explaining an example of the method for setting extraction conditions for log data of construction history data.
[FIG. 25] FIG. 25 is a flowchart showing the flow of the terrain data generation and output process executed by the management controller.
[FIG. 26A] FIG. 26A is a diagram showing the terrain data generated by the terrain data generation system according to the present embodiment.
[FIG. 26B] FIG. 26B is a diagram showing the terrain data generated by the terrain data generation system according to a comparative example of the present embodiment.

[FIG. 27] FIG. 27 is a flowchart showing the flow of the recording point setting process executed by the vehicle body controller according to a first modification of the present embodiment.

[FIG. 28] FIG. 28 is a flowchart showing the flow of the surface area setting process executed by the vehicle body controller according to a second modification of the present embodiment.

[FIG. 29A] FIG. 29A is a diagram showing an example of a distance threshold table.

[FIG. 29B] FIG. 29B is a diagram showing the concave and convex parts of the target shape.

Modes for Carrying Out the Invention

With reference to the drawings, a work machine management system according to an embodiment of the present invention will be described. The work machine is a machine used for various tasks such as civil engineering work, construction work, and demolition work. In this embodiment, an example in which the work machine is a crawler-mounted hydraulic excavator 100 will be described.

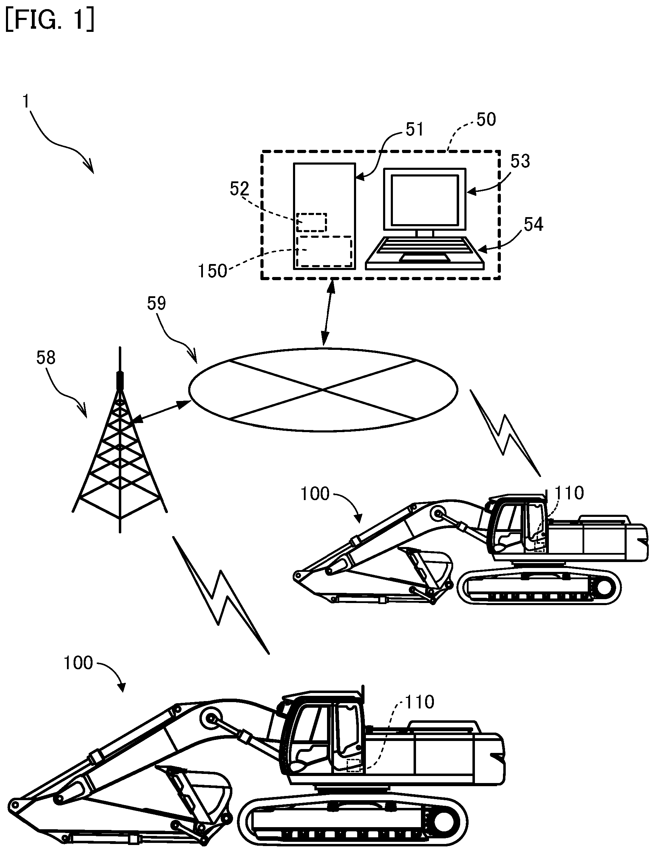

FIG. 1 is a diagram showing the configuration of the work machine management system 1. As shown in FIG. 1, the management system 1 includes a vehicle body controller 110 provided in the hydraulic excavator 100 that performs work at the work site, and a management controller 150 provided in the management server 51. The management server 51 is provided in a management center 50 installed at the work site or at a location remote from the work site. The management center 50 is installed, for example, in a facility of the manufacturer of the hydraulic excavator 100, a facility of the rental company of the hydraulic excavator 100, or a facility of the owner of the hydraulic excavator 100. The management server 51 is an external device that remotely manages the state of the hydraulic excavator 100.

The hydraulic excavator 100 and the management server 51 perform bidirectional communication via a communication line 59 of a wide area network. That is, the hydraulic excavator 100 and the management server 51 transmit and receive information (data) via the communication line 59. The communication line 59 is a mobile communication network (mobile network) deployed by a mobile phone operator or the like, or the Internet. The hydraulic excavator 100 is connected to the communication line 59 via a wireless base station 58, for example.

The management server 51 receives data received from the hydraulic excavator 100 and stores it in a storage device 52 such as a hard disk drive. The management server 51 displays the information (data) stored in the storage device 52 on a display device 53 such as a liquid crystal display device. The administrator can grasp the state of the hydraulic excavator 100 by operating the management server 51 with an input device 54 such as a keyboard or mouse, and displaying the information of the predetermined hydraulic excavator 100 on the display device 53.

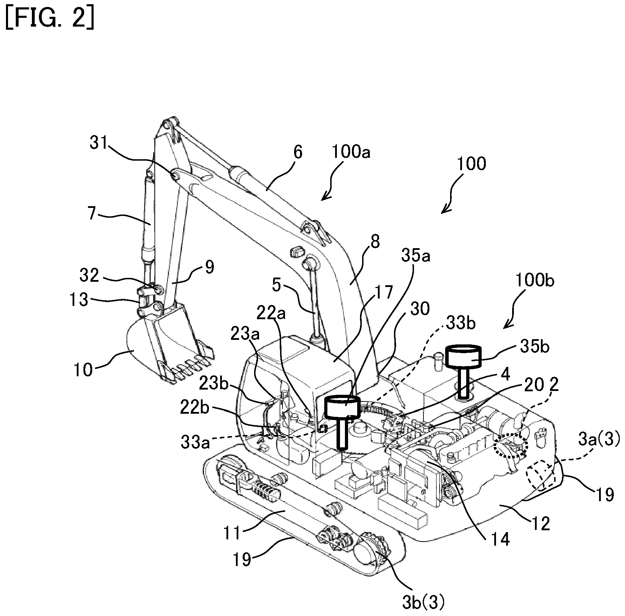

FIG. 2 is a configuration diagram of the hydraulic excavator 100. As shown in FIG. 2, the hydraulic excavator 100 includes a vehicle body (machine body) 100b and a work device 100a attached to the vehicle body 100b. The vehicle body 100b includes a travel body 11 and a swing body 12 that is pivotally mounted on the travel body 11, with a working device 100a attached to the front of the swing body 12. The hydraulic excavator 100 includes a travel hydraulic motor 3 (also referred to as the right travel hydraulic motor 3a) for driving the right crawler 19 of the travel body 11, and a travel hydraulic motor 3 (also referred to as the left travel hydraulic motor 3b) for driving the left crawler 19 of the travel body 11. The pair of left and right crawlers 19 are driven by the travel hydraulic motor 3, allowing the travel body 11 to move. The hydraulic excavator 100 includes a swing hydraulic motor 4 for pivoting (rotating) the swing body 12 relative to the travel body 11.

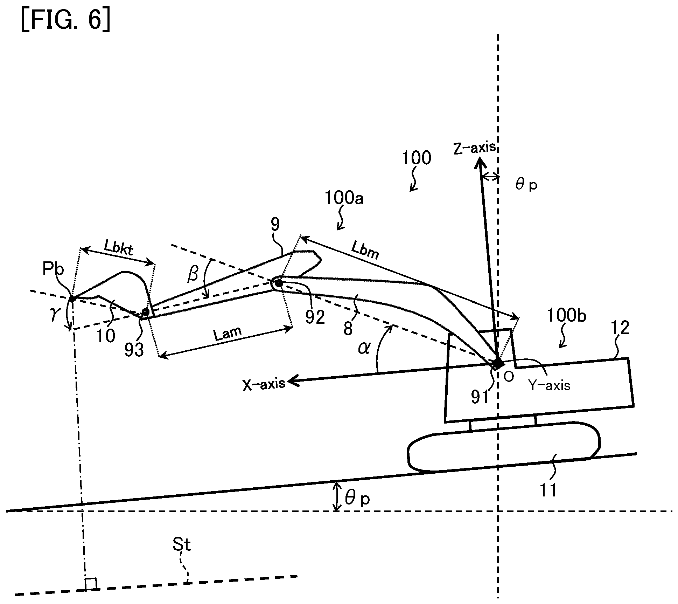

The working device 100a is an articulated working device having multiple driven members (front members) driven by multiple actuators. The working device 100a is configured with three driven members (boom 8, arm 9, and bucket 10) connected in series. The boom 8 is pivotally connected at its base end to the front of the swing body 12 via a boom pin 91 (see FIG. 6). The arm 9 is pivotally connected at its base end to the distal end of the boom 8 via an arm pin 92 (see FIG. 6). The bucket 10 is pivotally connected to the distal end of the arm 9 via a bucket pin 93 (see FIG. 6). The boom pin 91, arm pin 92, and bucket pin 93 are arranged parallel to each other, allowing each driven member (boom 8, arm 9, and bucket 10) to rotate relative to each other within the same plane.

The boom 8 is driven by a boom cylinder (hydraulic cylinder) 5, which is an actuator. The arm 9 is driven by an arm cylinder (hydraulic cylinder) 6, which is an actuator. The bucket 10 is driven by a bucket cylinder (hydraulic cylinder) 7, which is an actuator. The hydraulic cylinders (5-7) include a bottomed cylindrical cylinder tube with one end closed, and a head cover that seals the opening at the other end of the cylinder tube. Additionally, the cylinders (5-7) include a cylinder rod that passes through the hydraulic head cover and is inserted into the cylinder tube, and a piston provided at the tip of the cylinder rod, which divides the interior of the cylinder tube into a rod-side oil chamber and a bottom-side oil chamber. The boom cylinder 5 is connected at one end to the swing body 12 and at the other end to the boom 8. The arm cylinder 6 is connected at one end to the boom 8 and at the other end to the arm 9. The bucket cylinder 7 is connected at one end to the arm 9 and at the other end to the bucket 10 via a bucket link 13. By driving each hydraulic cylinder (5-7), operations such as excavation and grading of the ground are performed.

On the front left side of the swing body 12, an operator's cab 17 is provided for the operator to board. The operator's cab 17 is equipped with a right travel lever device 23a and a left travel lever device 23b for issuing operation instructions to the travel body 11. Additionally, the operator's cab 17 is equipped with a right operation lever device 22a and a left operation lever device 22b for issuing operation instructions to the boom 8, arm 9, bucket 10, and swing body 12. Thus, the hydraulic excavator 100 according to this embodiment is equipped with operation devices (22a, 22b, 23a, 23b) for operating the swing body 12, the working device 100a, and the travel body 11.

The swing body 12 is equipped with an engine 14 as a prime mover, a pump 2 driven by the engine 14, and a control valve unit 20. The control valve unit 20, not shown, includes multiple flow control valves (also referred to as directional control valves) and controls the flow (flow rate and direction) of hydraulic oil as the working fluid supplied from the pump 2 to the actuators (boom cylinder 5, arm cylinder 6, bucket cylinder 7, swing hydraulic motor 4, and travel hydraulic motor 3).

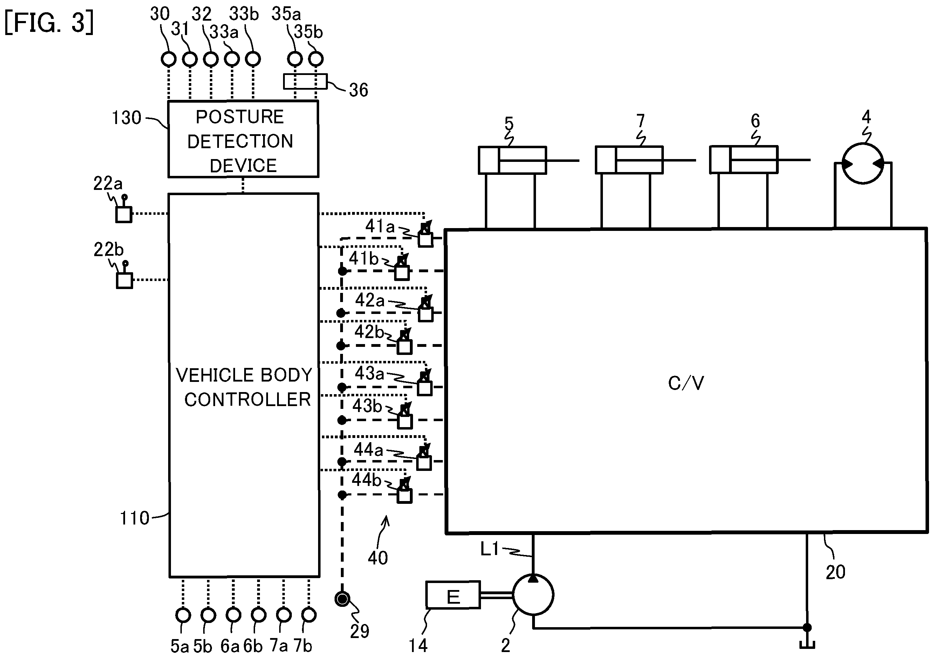

FIG. 3 is a diagram showing the configuration of the hydraulic drive system of the hydraulic excavator 100. For simplification of explanation, FIG. 3 describes the configuration for driving the boom cylinder 5, arm cylinder 6, bucket cylinder 7, and swing hydraulic motor 4, and omits the illustration of circuits, valves, etc., that are not directly related to this embodiment.

The pump 2 is driven by the engine 14, draws hydraulic oil from the tank, and discharges it into the pump line L1 that connects the control valve unit 20 and the discharge port of the pump 2. In FIG. 3, an example is shown where the pump 2 is a fixed displacement hydraulic pump, but a variable displacement hydraulic pump may also be used. Additionally, the pump 2 supplying hydraulic oil to the control valve unit 20 may be a single pump or multiple pumps.

The control valve unit 20 is controlled by a solenoid valve unit 40 having multiple electromagnetic proportional valves 41a to 44b, thereby controlling the flow of hydraulic oil (pressure oil) supplied from the pump 2 to the actuators. The control valve unit 20 controls the flow of hydraulic oil (pressure oil) supplied from the pump 2 to the boom cylinder 5 in response to the signal pressure generated by the electromagnetic proportional valves 41a, 41b. The control valve unit 20 controls the flow of hydraulic oil (pressure oil) supplied from the pump 2 to the arm cylinder 6 in response to the signal pressure generated by the electromagnetic proportional valves 42a, 42b. The control valve unit 20 controls the flow of hydraulic oil (pressure oil) supplied from the pump 2 to the bucket cylinder 7 in response to the signal pressure generated by the electromagnetic proportional valves 43a, 43b. The control valve unit 20 controls the flow of hydraulic oil (pressure oil) supplied from the pump 2 to the swing hydraulic motor 4 in response to the signal pressure generated by the electromagnetic proportional valves 44a, 44b.

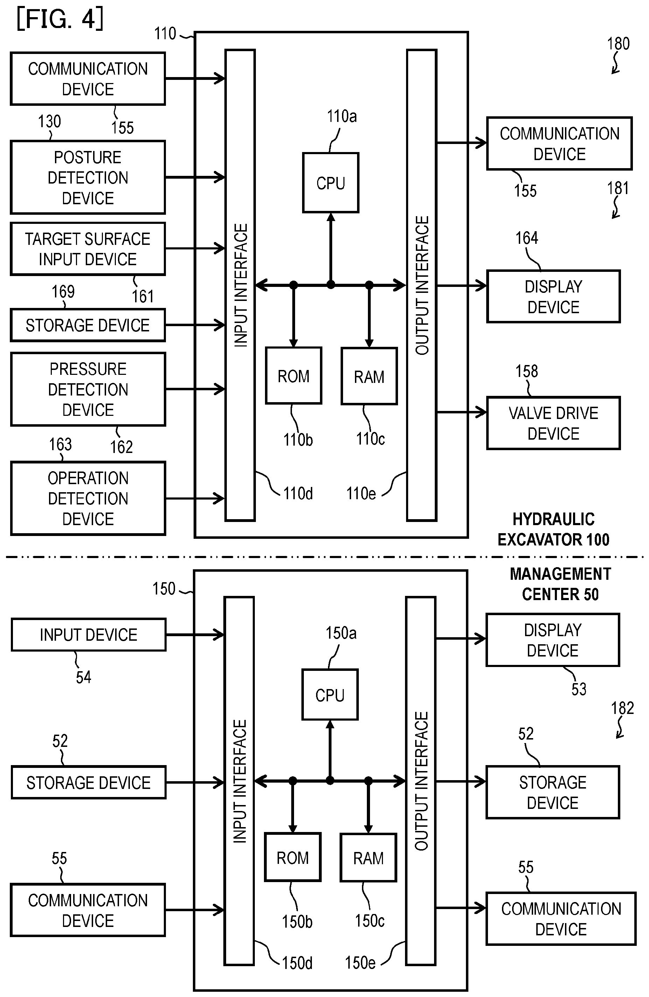

The electromagnetic proportional valves 41a to 44b use the pressure of pilot pressure oil supplied from the pilot hydraulic source 29 as the primary pressure (original pressure), and output the secondary pressure, generated by reducing the pressure according to the command current from the valve drive device 158 (see FIG. 4), as the signal pressure to the control valve unit 20. The pilot hydraulic source 29 is, for example, a hydraulic pump (pilot pump) driven by the engine 14.

The right operation lever device 22a includes an operation sensor that outputs a voltage signal (operation signal) corresponding to the operation amount and direction of the operation lever as boom operation information and bucket operation information to the vehicle body controller 110. The left operation lever device 22b includes an operation sensor that outputs a voltage signal (operation signal) corresponding to the operation amount and direction of the operation lever as arm operation information and swing operation information to the vehicle body controller 110.

When operation signals from the operation sensors of the operation devices 22a, 22b are input to the vehicle body controller 110, the vehicle body controller 110 controls the electromagnetic proportional valves 41a to 44b of the solenoid valve unit 40 so that the actuators operate at an operation speed corresponding to the operation signals. As a result, the control valve unit 20 is controlled, hydraulic oil discharged from the pump 2 is supplied to the actuators, and the actuators operate.

When a boom raise operation is performed by the operation device 22a, the command pressure corresponding to the operation amount is output from the electromagnetic proportional valve 41a to the first pressure receiving part of the flow control valve for the boom, and the flow control valve for the boom operates to one side (boom raise side). As a result, hydraulic oil is supplied to the bottom-side oil chamber of the boom cylinder 5, and hydraulic oil is discharged from the rod-side oil chamber of the boom cylinder 5 to the tank. As a result, the boom cylinder 5 extends, and the boom 8 pivots upward around the boom pin 91. When a boom lower operation is performed by the operation device 22a, the command pressure corresponding to the operation amount is output from the electromagnetic proportional valve 41b to the second pressure receiving part of the flow control valve for the boom, and the flow control valve for the boom operates to the other side (boom lower side). As a result, hydraulic oil is supplied to the rod-side oil chamber of the boom cylinder 5, and hydraulic oil is discharged from the bottom-side oil chamber of the boom cylinder 5 to the tank. As a result, the boom cylinder 5 contracts, and the boom 8 pivots downward around the boom pin 91.

When a bucket roll-in operation is performed by the operation device 22a, the command pressure corresponding to the operation amount is output from the electromagnetic proportional valve 43a to the first pressure receiving part of the flow control valve for the bucket, and the flow control valve for the bucket operates to one side (bucket roll-in side). As a result, hydraulic oil is supplied to the bottom-side oil chamber of the bucket cylinder 7, and hydraulic oil is discharged from the rod-side oil chamber of the bucket cylinder 7 to the tank. As a result, the bucket cylinder 7 extends, and the bucket 10 pivots downward around the bucket pin 93. That is, the bucket roll-in operation is performed. When a bucket dump

EP 4 585 756 A1

operation is performed by the operation device 22a, the command pressure corresponding to the operation amount is output from the electromagnetic proportional valve 43b to the second pressure receiving part of the flow control valve for the bucket, and the flow control valve for the bucket operates to the other side (bucket dump side). As a result, hydraulic oil is supplied to the rod-side oil chamber of the bucket cylinder 7, and hydraulic oil is discharged from the bottom-side oil chamber of the bucket cylinder 7 to the tank. As a result, the bucket cylinder 7 contracts, and the bucket 10 pivots upward around the bucket pin 93. That is, the bucket dump operation is performed.

When an arm roll-in operation is performed by the operation device 22b, the command pressure corresponding to the operation amount is output from the electromagnetic proportional valve 42a to the first pressure receiving part of the flow control valve for the arm, and the flow control valve for the arm operates to one side (arm roll-in side). As a result, hydraulic oil is supplied to the bottom-side oil chamber of the arm cylinder 6, and hydraulic oil is discharged from the rod-side oil chamber of the arm cylinder 6 to the tank. Consequently, the arm cylinder 6 extends, and the arm 9 rotates downward around the arm pin 92 as a fulcrum. In other words, the roll-in operation is performed. When the arm dump operation is performed by the operating device 22b, the command pressure corresponding to the operation amount is output from the electromagnetic proportional valve 42b to the second pressure receiving part of the flow control valve for the arm, and the flow control valve for the arm operates on the other side (arm dump side). As a result, hydraulic oil is supplied to the rod-side oil chamber of the arm cylinder 6, and hydraulic oil is discharged from the bottom-side oil chamber of the arm cylinder 6 to the tank. Consequently, the arm cylinder 6 contracts, and the arm 9 rotates upward around the arm pin 92 as a fulcrum. In other words, the arm dump operation is performed.

When the actuators (5, 6, 7) operate to rotate the driven members (8, 9, 10), the posture of the working device 100a and the position of the tip of the bucket 10 change.

When a right swing operation is performed by the operating device 22b, a command pressure corresponding to the operation amount is output from the electromagnetic proportional valve 44a to the first pressure receiving part of the flow control valve for swinging, causing the flow control valve for swinging to operate on one side (right swing side). As a result, hydraulic oil is supplied to the swing hydraulic motor 4, and the swing hydraulic motor 4 rotates in one direction (right swing direction) 11. Consequently, the swing body 12 swings to the right with respect to the travel body 11. When a left swing operation is performed by the operating device 22b, a command pressure corresponding to the operation amount is output from the electromagnetic proportional valve 44b to the second pressure receiving part of the flow control valve for swinging, causing the flow control valve for swinging to operate on the other side (left swing side). As a result, hydraulic oil is supplied to the swing hydraulic motor 4, and the swing hydraulic motor 4 rotates in the other direction (left swing direction). Consequently, the swing body 12 swings to the left with respect to the travel body 11. When the swing body 12 swings with respect to the travel body 11 due to the operation of the swing hydraulic motor 4, the position of the tip of the bucket 10 changes.

The hydraulic excavator 100 is equipped with pressure sensors 5a to 7b that detect the pressure (cylinder pressure) in the boom cylinder 5, arm cylinder 6, and bucket cylinder 7, and output the detection results (electrical signals) to the vehicle body controller 110. Pressure sensor 5a detects the pressure in the rod-side oil chamber of the boom cylinder 5, and pressure sensor 5b detects the pressure in the bottom-side oil chamber of the boom cylinder 5. Pressure sensor 6a detects the pressure in the rod-side oil chamber of the arm cylinder 6, and pressure sensor 6b detects the pressure in the bottom-side oil chamber of the arm cylinder 6. Pressure sensor 7a detects the pressure in the rod-side oil chamber of the bucket cylinder 7, and pressure sensor 7b detects the pressure in the bottom-side oil chamber of the bucket cylinder 7.

As shown in FIG. 2, a boom angle sensor 30 for measuring the rotation angle of the boom 8 relative to the swing body 12 (hereinafter referred to as the boom angle) $\alpha$ (see FIG. 6) is attached to the boom 8. An arm angle sensor 31 for measuring the rotation angle of the arm 9 relative to the boom 8 (hereinafter referred to as the arm angle) $\beta$ (see FIG. 6) is attached to the arm 9. A bucket angle sensor 32 for measuring the rotation angle of the bucket 10 relative to the arm 9 (hereinafter referred to as the bucket angle) $\gamma$ (see FIG. 6) is attached to the bucket link 13. The bucket angle sensor 32 may be attached to the bucket 10 instead of the bucket link 13. A vehicle body front-rear inclination angle sensor 33a for measuring the inclination angle in the front-rear direction of the swing body 12 (vehicle body 100b) relative to a reference plane (e.g., horizontal plane) (hereinafter referred to as the pitch angle) $\theta p$ (see FIG. 6) is attached to the swing body 12. Additionally, a vehicle body left-right inclination angle sensor 33b for measuring the inclination angle in the left-right direction of the swing body 12 (vehicle body 100b) relative to a reference plane (e.g., horizontal plane) (hereinafter referred to as the roll angle) $\theta r$ (not shown) is attached to the swing body 12.

The angle sensors 30, 31, 32, 33a, 33b according to this embodiment are IMUs (Inertial Measurement Units). The angle sensors 30, 31, 32, 33a, 33b may be sensors such as potentiometers or rotary encoders instead of IMUs.

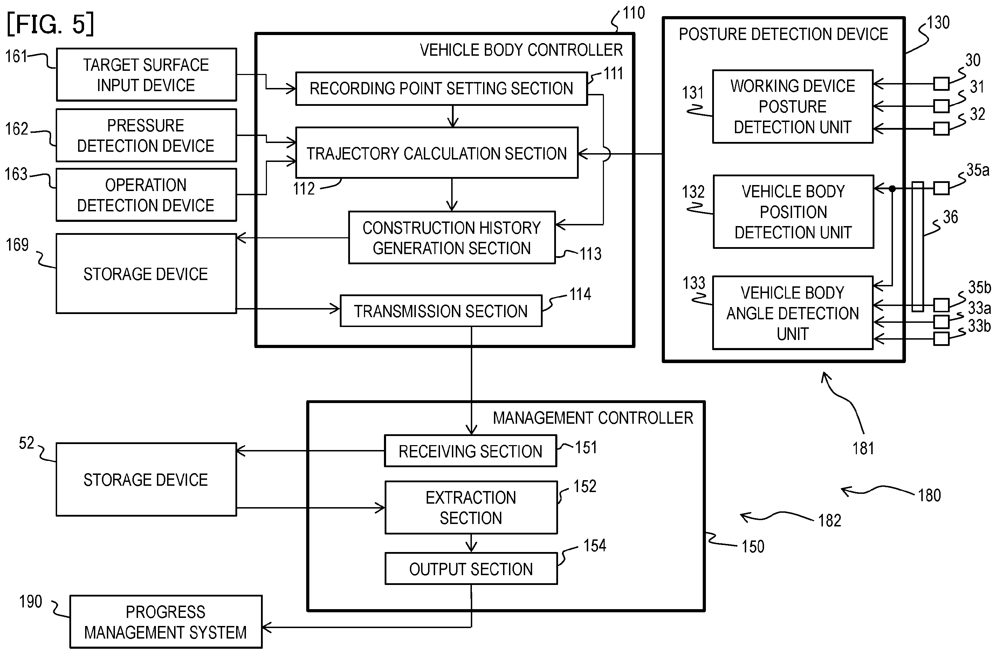

The hydraulic excavator 100 is equipped with a pair of left and right RTK-GNSS (Real Time Kinematic-Global Navigation Satellite Systems) antennas (first GNSS antenna 35a and second GNSS antenna 35b) on the swing body 12, and a GNSS receiver 36 (see FIGS. 3 and 5) mounted in the cab 17, which calculates the position information of the hydraulic excavator 100 using the radio waves received by the GNSS antennas 35a, 35b. The GNSS antennas 35a, 35b and the GNSS receiver 36 may be provided integrally or separately. The GNSS receiver 36 outputs the position information of the GNSS antennas 35a, 35b to the vehicle body controller 110.

The angle sensors 30, 31, 32, 33a, 33b, and the GNSS antennas 35a, 35b function as attitude sensors for detecting the posture of the hydraulic excavator 100. Additionally, the GNSS antennas 35a, 35b function as position sensors for detecting the position of the hydraulic excavator 100.

As shown in FIG. 3, the hydraulic excavator 100 includes a posture detection device 130 that detects (calculates) the position, orientation, and posture of the hydraulic excavator 100 (the posture of the working device 100a and the posture of the vehicle body 100b) based on the detection results from the boom angle sensor 30, arm angle sensor 31, bucket angle sensor 32, vehicle body front-rear inclination angle sensor 33a, and vehicle body left-right inclination angle sensor 33b, as well as the position information from the GNSS antennas 35a, 35b.

The posture detection device 130 calculates the position of the hydraulic excavator 100 in the site coordinate system, as well as the attitude information representing the posture of the hydraulic excavator 100, including the boom angle $\alpha$, arm angle $\beta$, bucket angle $\gamma$, pitch angle $\theta p$, roll angle $\theta r$, and yaw angle $\theta y$, and outputs this information to the vehicle body controller 110.

Referring to FIGS. 4 and 5, the terrain data generation system 180, which generates terrain data indicating the final shape by the working device 100a of the hydraulic excavator 100, will be described. First, referring to FIG. 4, the main hardware configuration of the terrain data generation system 180 will be described. FIG. 4 is a hardware configuration diagram of the terrain data generation system 180.

As shown in FIG. 4, the terrain data generation system 180 includes a construction history calculation system 181 and a terrain data calculation system 182. The construction history calculation system 181 is mounted on the hydraulic excavator 100. The construction history calculation system 181 includes a vehicle body controller 110, a communication device 155 for communicating with a management server 51, and the posture detection device 130 for detecting (calculating) the posture of the hydraulic excavator 100. Additionally, the construction history calculation system 181 includes a target surface input device 161 for inputting target surface data to the vehicle body controller 110, a pressure detection device 162 for detecting the pressure of the hydraulic cylinders (5 to 7), an operation detection device 163 for detecting the operation amount of the operating devices 22a, 22b, and a storage device 169 for storing information. The storage device 169 is a non-volatile memory such as a flash memory or a hard disk drive.

The communication device 155 is a wireless communication device capable of wireless communication with a wireless base station 58 connected to a communication line 59, and includes a communication interface with a communication antenna having a predetermined frequency band as a receptive band. The communication device 155 may use communication methods such as Wi-Fi (registered trademark), ZigBee (registered trademark), or Bluetooth (registered trademark) to directly or indirectly exchange information with the management server 51.

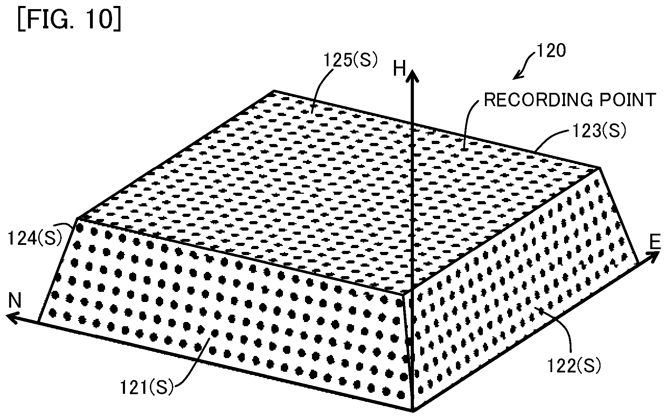

The target surface input device 161 is a device capable of inputting target surface data to the vehicle body controller 110. The target surface data includes position information and the like of multiple constituent surfaces that make up the target surface St (see FIG. 6). The target surface data has a data structure based on, for example, a triangular mesh model or a quadrilateral mesh model. The target surface data includes the coordinates of multiple nodes, the edges connecting the nodes, and information on the constituent surface S (see FIG. 10, etc.) surrounded by multiple edges. Data exchange between the target surface input device 161 and the vehicle body controller 110 may be conducted via wired communication, wireless communication, or through recording media such as USB flash memory or SD cards.

The pressure detection device 162 includes pressure sensors 5a to 7b, detects the pressure in the rod-side oil chamber and the bottom-side oil chamber of the hydraulic cylinders 5 to 7 that drive the driven members of the working device 100a, and outputs the detection results to the vehicle body controller 110. The operation detection device 163 includes operation sensors for the operating devices 22a, 22b, detects the operation amount and operation direction of the operating devices 22a, 22b, and outputs the detection results to the vehicle body controller 110.

A display device 164 is provided in the cab 17 of the hydraulic excavator 100. The display device 164 is a liquid crystal display device that displays images on the display screen based on the display control signals output from the vehicle body controller 110. The valve drive device 158 controls the command current supplied to the solenoids of the electromagnetic proportional valves 41a to 44b of the solenoid valve unit 40 based on the valve drive signals output from the vehicle body controller 110.

The terrain data calculation system 182 is provided in the management center 50. The terrain data calculation system 182 includes a management controller 150, a communication device 55 for communicating with the hydraulic excavator 100, input devices 54 such as a keyboard and mouse for inputting predetermined information to the management controller 150 by the administrator's operation, a display device 53 such as a liquid crystal display device, and a storage device 52 for storing information.

The communication device 55 is a communication device capable of communicating with the hydraulic excavator 100 via a communication line 59, which is a wide area network. The communication device 55 may use communication methods such as Wi-Fi (registered trademark), ZigBee (registered trademark), and Bluetooth (registered trademark) to directly or indirectly exchange information with the hydraulic excavator 100.

The vehicle body controller 110 and the management controller 150 are composed of microcomputers equipped with operational circuits such as CPU (Central Processing Unit) 110a, 150a, storage devices such as ROM (Read Only Memory) 110b, 150b and RAM (Random Access Memory) 110c, 150c, input interfaces 110d, 150d, and output interfaces 110e, 150e, as well as other peripheral circuits. The vehicle body controller 110 and the management controller 150 may each be composed of a single computer or multiple computers.

The input interfaces 110d, 150d convert signals from various devices so that the CPUs 110a, 150a can process them. ROM 110b, 150b are non-volatile memories such as EEPROM. ROM 110b, 150b store programs that can execute various operations by CPUs 110a, 150a as shown in the flowchart described later. That is, ROM 110b, 150b are readable storage media for programs that implement the functions of this embodiment.

Additionally, ROM 110b stores various data such as dimension information and thresholds for the hydraulic excavator 100. For example, ROM 110b stores the length Lbm from the center position of the boom pin 91 to the center position of the arm pin 92, the length Lam from the center position of the arm pin 92 to the center position of the bucket pin 93, and the length Lbkt from the center position of the bucket pin 93 to the tip Pb of the bucket 10 as dimension information for the hydraulic excavator 100. Additionally, ROM 110b stores information regarding the mounting positions of hydraulic cylinders (5-7) (e.g., the distance from the boom pin 91 to the rod-side connection of the boom cylinder 5, the distance from the boom pin 91 to the bottom-side connection of the boom cylinder 5, etc.) as dimension information for the hydraulic excavator 100. Furthermore, ROM 110b stores the position coordinates of GNSS antennas 35a, 35b in the shovel reference coordinate system. The position coordinates of GNSS antennas 35a, 35b in the shovel reference coordinate system can be calculated based on design dimensions or measurement results from instruments such as a total station.

RAM 110c, 150c are volatile memories that serve as work memories for direct data input and output with CPUs 110a, 150a. RAM 110c, 150c temporarily store necessary data while CPUs 110a, 150a are executing program calculations.

CPUs 110a, 150a are processing units that expand and execute programs stored in ROM 110b, 150b in RAM 110c, 150c, performing predetermined processing on signals acquired from input interfaces 110d, 150d and ROM 110b, 150b, RAM 110c, 150c according to the program. Output interfaces 110e, 150e generate output signals corresponding to the calculation results of CPUs 110a, 150a and output these signals to various devices.

Next, referring to FIG. 5, the main functions of the terrain data generation system 180 are described. FIG. 5 is a functional block diagram showing the main functions of the terrain data generation system 180. As shown in FIG. 5, the vehicle body controller 110 functions as a first processing device that executes the generation process of construction history data based on the posture of the hydraulic excavator 100 detected by the posture detection device 130. The management controller 150 functions as a second processing device that executes the calculation processing of terrain data indicating the as-built shape by the working device 100a of the hydraulic excavator 100 based on the position information of the trajectory of the working device 100a included in the construction history data.

As shown in FIG. 5, the posture detection device 130 functions as a working device posture detection unit 131, a vehicle body position detection unit 132, and a vehicle body angle detection unit 133. The working device posture detection unit 131 calculates the boom angle $\alpha$, arm angle $\beta$, and bucket angle $\gamma$ based on the detection results from the boom angle sensor 30, arm angle sensor 31, and bucket angle sensor 32, and outputs the calculation results to the vehicle body controller 110.

The vehicle body position detection unit 132 calculates the antenna position information in the site coordinate system based on the position information of the first GNSS antenna 35a output from the GNSS receiver 36 and outputs it to the vehicle body controller 110. The vehicle body position detection unit 132 executes coordinate conversion processing to convert the position information of a coordinate system other than the site coordinate system into the position information of the site coordinate system when such information is input, and calculates the antenna position information in the site coordinate system.

In this embodiment, the case where the GNSS receiver 36 outputs the coordinates (coordinate values) of the site coordinate system is described. The GNSS receiver 36 may output coordinates of at least one or more coordinate systems such as a geographic coordinate system, a plane rectangular coordinate system, a geocentric orthogonal coordinate system, or a site coordinate system. Coordinates in the geographic coordinate system consist of latitude, longitude, and ellipsoidal height, while coordinates in the plane rectangular coordinate system, geocentric orthogonal coordinate system, and site coordinate system consist of a three-dimensional orthogonal coordinate system such as X, Y, Z coordinates. Coordinates in the geographic coordinate system can be converted into coordinates of a three-dimensional orthogonal coordinate system such as a plane rectangular coordinate system using methods such as the Gauss-Krüger conformal projection. Additionally, coordinates in the plane rectangular coordinate system, geocentric orthogonal coordinate system, and site coordinate system can be mutually converted using methods such as affine transformation or Helmert transformation.

The site coordinate system in this embodiment is a coordinate system that takes any position at the work site as the origin, with the E-axis in the east direction on the horizontal plane, the N-axis in the north direction on the horizontal plane, and the H-axis in the vertical upward direction.

The vehicle body angle detection unit 133 calculates the azimuth angle $\theta y$, pitch angle $\theta p$, and roll angle $\theta r$ based on the antenna position information of the first GNSS antenna 35a and the second GNSS antenna 35b, as well as the detection results (sensor values) from the vehicle body front-rear inclination angle sensor 33a and the vehicle body left-right inclination angle sensor 33b, and outputs the calculation results to the vehicle body controller 110. The vehicle body angle detection unit 133 calculates the azimuth angle $\theta y$ from the positional relationship between the first GNSS antenna 35a and the second GNSS antenna 35b.

The vehicle body controller (first processing device) 110 of the hydraulic excavator 100 generates construction history data based on the posture of the hydraulic excavator 100 detected by the posture detection device 130 and executes the process of transmitting the generated construction history data to an external management server 51 of the hydraulic excavator 100. The functions of the vehicle body controller 110 are described in detail below.

The vehicle body controller 110 functions as a recording point setting section 111, a trajectory calculation section 112, a construction history generation section 113, and a transmission section 114. The recording point setting section 111 calculates the coordinates of the recording points (working machine trajectory recording positions) of the trajectory of the monitor points of the working device 100a, which will be described later, and the direction vector at the recording points when it acquires target surface data from the target surface input device 16.

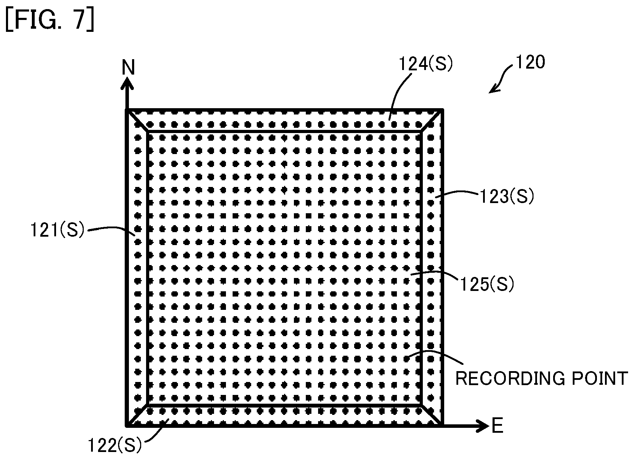

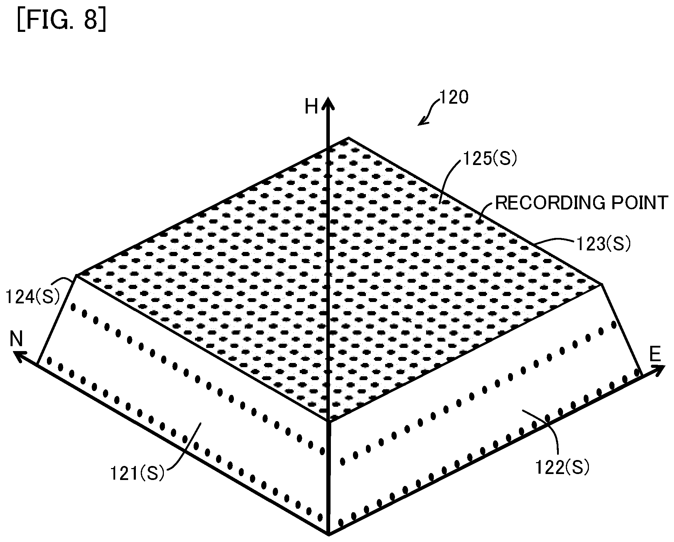

The method for setting recording points by the recording point setting section 111 is described. First, referring to FIGS. 7 and 8, an example where recording points are set at equal intervals in the horizontal direction is described. FIG. 7 is a plan schematic diagram of the target shape 120, and FIG. 8 is a perspective view of the target shape 120. FIGS. 7 and 8 show an example where recording points (black-filled circle marks in the figure) are set at equal intervals in the E-axis direction and N-axis direction when viewed from the vertical upward direction. The recording points are used in the construction history generation section 113, which will be described later, when recording the position information (ENH coordinates) of the trajectory of the bucket 10 as construction history data.

As shown in FIGS. 7 and 8, the target surface data is data that defines the target shape 120 by multiple constituent surfaces S. The target shape 120 has a square top surface area 125 as a constituent surface S and slope areas 121, 122, 123, 124 as four constituent surfaces S connected to each side of the top surface area 125, presenting a truncated pyramid shape. In the example shown in FIG. 7, the recording points are set at regular intervals in the horizontal direction (E-axis direction and N-axis direction). Therefore, as shown in FIG. 8, the number of recording points per unit area in the steep slope areas 121 to 124 is less than the number of recording points per unit area in the top surface area 125. In other words, the point density [points/m$^2$] representing the number of recording points per unit area in the slope areas 121 to 124 is smaller than the point density of the recording points in the top surface area 125. Thus, when recording points are arranged at regular intervals in the E-axis direction and N-axis direction for multiple constituent surfaces S, the point density of recording points becomes smaller for constituent surfaces S with a large inclination angle relative to the reference plane (E-N plane). A higher point density of recording points allows for more accurate generation of terrain data. In the example shown in FIGS. 7 and 8, the accuracy of the shape of the slope areas 121 to 124 is lower than that of the top surface area 125.

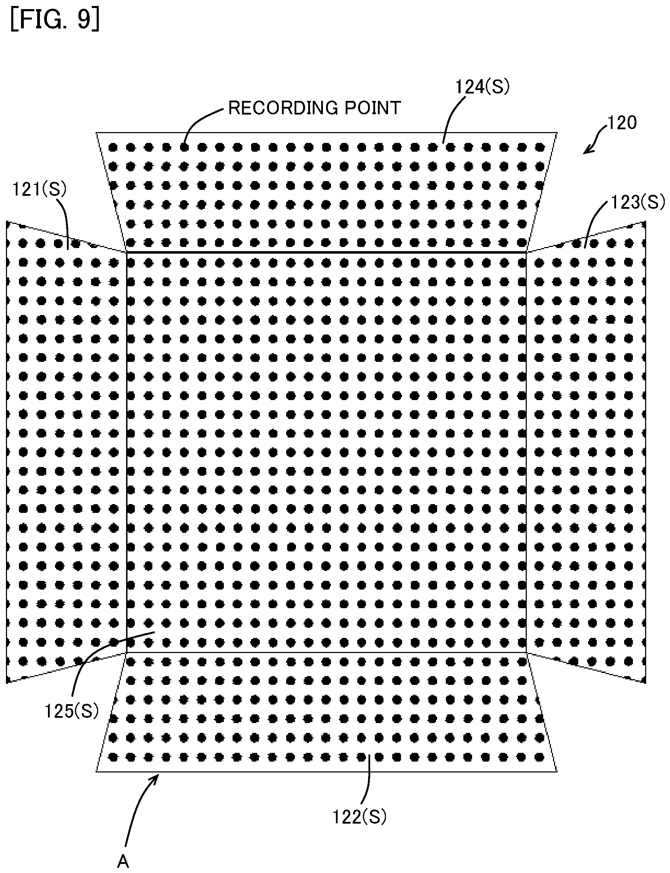

Therefore, the recording point setting section 111 according to this embodiment sets multiple recording points for each constituent surface S of the target surface data based on the acquired target surface data, so that the predetermined point density $\rho S$ is achieved. Specifically, the recording point setting section 111 sets the recording points so that the point density of the recording points in the top surface area 125 is the same as that in the slope areas 121 to 124. In other words, the recording point setting section 111 sets the recording points for all constituent surfaces S of the target surface data to achieve a constant point density $\rho S$. The point density $\rho S$ is pre-stored in ROM 110b. Referring to FIGS. 9 to 16, the method of setting recording points by the recording point setting section 111 according to this embodiment will be described.

FIG. 9 is a development view of the target shape 120, showing an example of the arrangement of recording points according to this embodiment. FIG. 10 is a perspective view of the target shape 120, showing an example of the arrangement of recording points according to this embodiment. As shown in FIG. 9, the method of setting recording points according to this embodiment involves unfolding the surfaces (top surface area 125, slope areas 121 to 124) that constitute the target shape 120 and arranging the recording points at a constant point density on the development view. Specifically, the recording point setting section 111 sets multiple recording points for the multiple constituent surfaces S that make up the target surface data as surface area A, so that the predetermined point density $\rho S$ is achieved for this surface area A. For example, the recording point setting section 111 sets the top surface area 125 as the target constituent surface for setting recording points, and the slope areas 121 to 124 adjacent to the top surface area 125 as adjacent constituent surfaces, thereby setting a single surface area A with these five constituent surfaces S. The recording point setting section 111 sets the recording points for all constituent surfaces S of the target surface data to achieve a constant point density. This allows, as shown in FIG. 10, for recording points to be arranged at the same point density on inclined surfaces like the slope areas 121 to 124, as on the top surface area 125 parallel to the E-N plane.

In this embodiment, by unfolding the constituent surfaces S that make up the target shape 120 onto the E-N plane, recording points are arranged at equal intervals for each constituent surface S using the same reference point, the same first reference axis E, and the same second reference axis N. It should be noted that the method of setting recording points is not limited to this. Different reference points and reference axes may be set for each constituent surface S. For example, any edge of the constituent surface S may be set as the first reference axis of that constituent surface S, and an axis parallel to the constituent surface S and orthogonal to the first reference axis may be set as the second reference axis.

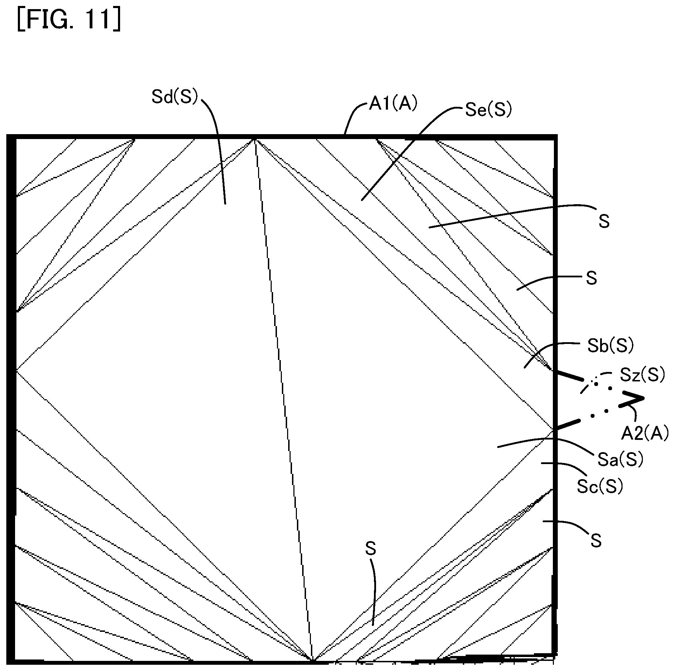

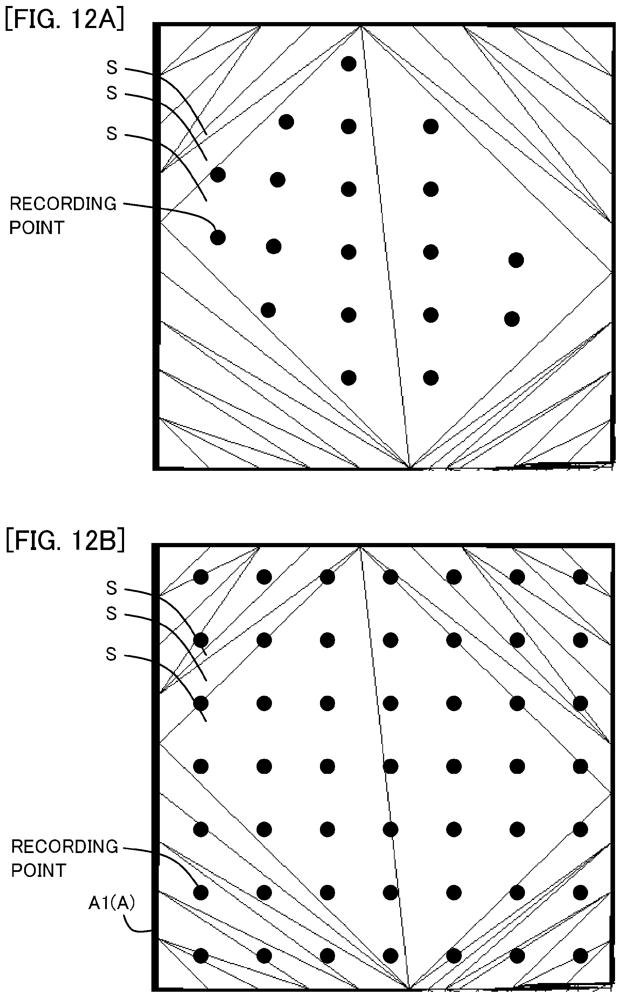

Note that when arranging recording points at equal intervals in the E-axis and N-axis directions, as explained below, recording points may not be appropriately arranged on the constituent surface S. Referring to FIG. 11, an example where recording points are not appropriately arranged on the constituent surface S will be described. FIG. 11 is a diagram showing an example of target surface data where the surface on the same plane is finely divided. When the target surface input device 161 automatically generates target surface data using CAD software (CAD: Computer-Aided Design) or the like, depending on the method of dividing the target shape 120, as shown in FIG. 11, constituent surfaces S that are complexly divided may be formed even though they are on the same plane. Here, for example, when arranging recording points at a predetermined point density where one point is placed per n[m$^2$], as shown in FIG. 12A, if the finely divided constituent surface S is less than n[m$^2$], no recording points will be placed on that constituent surface S. In this case, when viewed across the entire target surface data, there is a risk that recording points may not be arranged at a sufficient point density.

Therefore, in this embodiment, a set of multiple constituent surfaces S that continuously exist on the same plane, and multiple continuous constituent surfaces S that form a gentle curved surface are treated as the same surface area A, and recording points are arranged at a constant point density for each surface area A. In this embodiment, one or more constituent surfaces S constitute one surface area A. The recording point setting section 111 sets adjacent constituent surfaces S as the same surface area A if the angle $\varphi$ between the normals of adjacent constituent surfaces S among the multiple constituent surfaces S that make up the acquired target surface data is less than a predetermined angle threshold $\varphi 0$. Additionally, the recording point setting section 111 sets adjacent constituent surfaces S as different surface areas A if the angle $\varphi$ between the normals of adjacent constituent surfaces S among the multiple constituent surfaces S that make up the acquired target surface data is equal to or greater than the angle threshold $\varphi 0$. The angle threshold $\varphi 0$ is pre-stored in ROM 110b.

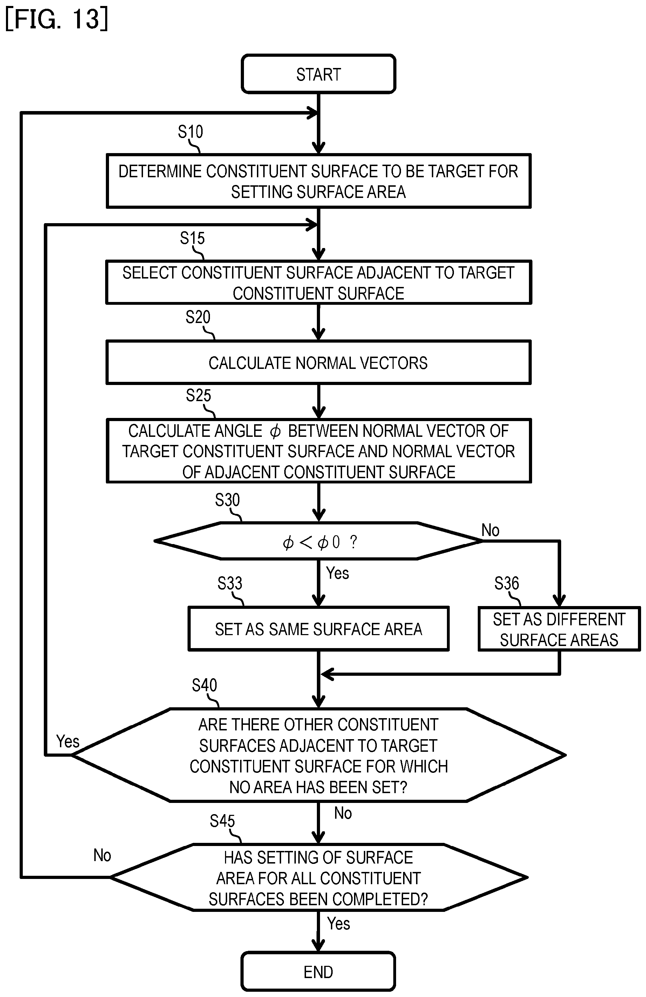

Referring to FIG. 13, the content of the process for setting surface area A by the recording point setting section 111 will be described. The process shown in the flowchart of FIG. 13 is initiated, for example, when the ignition switch (not shown) of the excavator 100 is turned on.

As shown in FIG. 13, in step S10, the recording point setting section 111 determines the initial constituent surface to be the target for setting surface area A and proceeds to step S15. In step S15, the recording point setting section 111 selects a constituent surface (adjacent constituent surface) adjacent to the constituent surface (target constituent surface) that is the target for setting recording points and proceeds to step S20. The adjacent constituent surface is a constituent surface that shares at least one edge with the target constituent surface.

In step S20, the recording point setting section 111 calculates the normal vectors of the target constituent surface and the adjacent constituent surface and proceeds to step S25. In step S25, the recording point setting section 111 calculates the angle $\varphi$ between the normal vectors of the target constituent surface and the adjacent constituent surface and proceeds to step S30.

In step S30, the recording point setting section 111 determines whether the angle $\varphi$ calculated in step S25 is less than the angle threshold $\varphi 0$. In step S30, if it is determined that the angle $\varphi$ is less than the angle threshold $\varphi 0$, the process proceeds to step S33. In step S30, if it is determined that the angle $\varphi$ is equal to or greater than the angle threshold $\varphi 0$, the process proceeds to step S36.

In step S33, the recording point setting section 111 sets the target constituent surface and the adjacent constituent surface as the same surface area A and proceeds to step S40. In step S36, the recording point setting section 111 sets the target constituent surface and the adjacent constituent surface as different surface areas A and proceeds to step S40.

In step S40, the recording point setting section 111 determines whether there are other constituent surfaces S adjacent to the target constituent surface for which the area setting process (step S33 or step S36) has not been performed. In step S40, if it is determined that there are other constituent surfaces S adjacent to the target constituent surface for which the area setting process has not been performed, the process returns to step S15. Note that in step S15, the recording point setting section 111 does not set as the target constituent surface any constituent surface S for which the area setting process has already been performed. In step S15, the recording point setting section 111 selects as the adjacent constituent surface any constituent surface S adjacent to the target constituent surface for which the area setting process (step S33 or step S36) has not been performed and proceeds to step S20.

In step S40, if it is determined that there are no other constituent surfaces S adjacent to the target constituent surface for which the area setting process has not been performed, the process proceeds to step S45. In step S45, the recording point setting section 111 determines whether the setting of surface area A has been completed for all constituent surfaces S that make up the target surface data.

In step S45, if it is determined that the setting of surface area A has not been completed for all constituent surfaces S that make up the target surface data, the process returns to step S10. In step S10, the recording point setting section 111 determines the next constituent surface S to be the target for setting surface area A and proceeds to step S15. Note that the recording point setting section 111 does not determine as the target constituent surface any constituent surface S that has once been determined as the target constituent surface. In other words, the recording point setting section 111 determines as the target constituent surface any constituent surface S that has not yet been determined as the target constituent surface.

In step S45, if it is determined that the setting of surface area A has been completed for all constituent surfaces S that make up the target surface data, the recording point setting section 111 ends the process shown in the flowchart of FIG. 13.

FIG. 11 is a diagram illustrating a specific example of the process for setting surface area A for the constituent surface S. As shown in FIG. 11, the recording point setting section 111 determines the constituent surface Sa as the target constituent surface. The recording point setting section 111 selects the constituent surface Sb adjacent to the constituent surface Sa. The recording point setting section 111 calculates the angle $\varphi$ between the normal vector of the target constituent surface Sa and the normal vector of the adjacent constituent surface Sb.

The recording point setting section 111 determines whether the angle $\varphi$ between the normal vector of the constituent surface Sa and the normal vector of the constituent surface Sb is less than the angle threshold $\varphi 0$. The recording point setting section 111 sets the constituent surfaces Sa and Sb as the same area if the angle $\varphi$ is less than the angle threshold $\varphi 0$. For example, the constituent surfaces Sa and Sb are each set as the first surface area A1. The recording point setting section 111 performs the same process for other constituent surfaces Sc and Sd adjacent to the target constituent surface Sa. In the example shown in FIG. 11, the constituent surfaces Sc and Sd are set as the same area as the constituent surface Sa, similar to the constituent surface Sb. In other words, the constituent surfaces Sa, Sb, Sc, and Sd are each set as the first surface area A1.

The recording point setting section 111 changes the target constituent surface and performs similar processing. For example, the recording point setting section 111 sets the constituent surface Sb as the next target constituent surface. The recording point setting section 111 determines whether the angle $\varphi$ formed by the normal vector of the target constituent surface Sb and the normal vectors of the adjacent constituent surfaces Se, Sz is less than the angle threshold $\varphi 0$. The recording point setting section 111 sets the constituent surfaces Sb and Se as the same region if the angle $\varphi$ between the normal vectors of the constituent surfaces Sb and Se is less than the angle threshold $\varphi 0$. In other words, the constituent surface Se is set as the same first surface area A1 as the constituent surfaces Sa, Sb, Sc, and Sd.

The recording point setting section 111 sets the constituent surfaces Sb and Sz as different regions if the angle $\varphi$ between the normal vectors of the constituent surfaces Sb and Sz is equal to or greater than the angle threshold $\varphi 0$. For example, the constituent surface Sz is set as the second surface area A2.

The recording point setting section 111 performs such processing for each constituent surface. As a result, in the example shown in FIG. 11, multiple constituent surfaces S within the rectangle indicated by the bold line are all set as the same first surface area A1. In other words, the rectangular first surface area A1 indicated by the bold line is composed of multiple triangular constituent surfaces S. The recording point setting section 111 arranges recording points in the set surface area A so that a predetermined point density $\rho S$ is achieved. This allows recording points to be arranged at an appropriate point density even if there are finely divided constituent surfaces S within the same plane, as shown in FIG. 12B. The recording points are arranged at equal intervals along the first and second reference axes parallel to one constituent surface S that constitutes the surface area A.

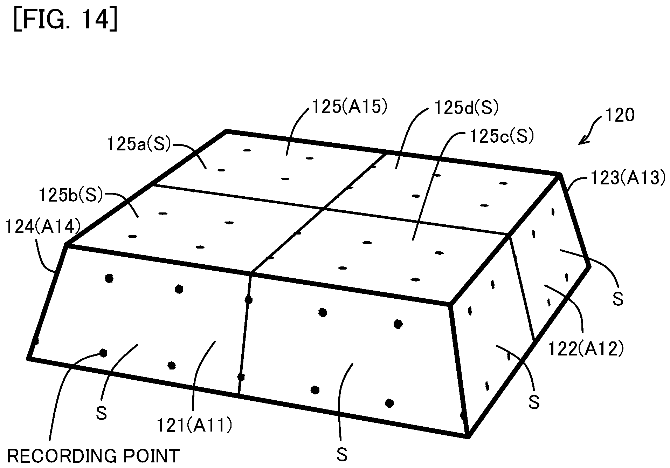

FIG. 14 is similar to FIG. 10 and shows an example where the target shape 120 in FIG. 10 is divided into four parts. To avoid complexity in the drawings, FIG. 14 illustrates the recording points in a thinned-out manner. In the example shown in FIG. 14, the top surface area 125 is divided into four parts, and the top surface area 125 is composed of four constituent surfaces 125a, 125b, 125c, and 125d. The recording point setting section 111 sets the four constituent surfaces 125a to 125d as the same surface area A15 and arranges recording points in this surface area A15 at a predetermined point density $\rho S$. Similarly, the recording point setting section 111 sets multiple constituent surfaces S on the same plane as the same surface areas A11 to A14 for the divided slope areas 121 to 124, and arranges recording points in each surface area A11 to A14 at a predetermined point density $\rho S$.

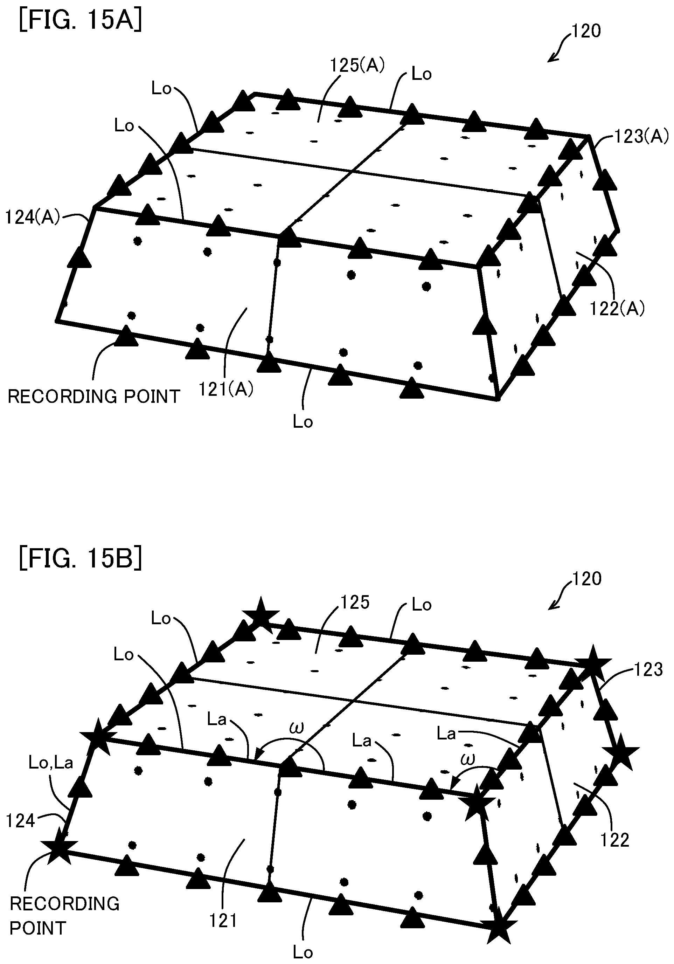

As shown in FIG. 14, depending on the position of the reference point for arranging recording points and the point density $\rho S$ of the recording points, recording points may not be arranged in parts that characterize the target shape 120, such as the toe and shoulder of the target shape 120. Therefore, the recording point setting section 111 according to this embodiment arranges recording points in each surface area A at a predetermined point density $\rho S$, and then adds and sets recording points at a predetermined line density $\rho L$ on the outer periphery of each surface area A, as indicated by the black-filled triangle mark ▲ in FIG. 15A. The line density $\rho L$ is pre-stored in ROM 110b. The recording point setting section 111 uses any point (position) on the outer periphery of the surface area A as a reference point and arranges recording points on the outer periphery at regular intervals. This allows for accurate representation of the shape of the toe and shoulder of the slope areas 121 to 124.

The recording point setting section 111 may set recording points at the endpoints of the outer peripheral line (straight or curved) Lo that constitutes the outer periphery of each surface area A, as indicated by the black-filled star mark ★ in FIG. 15B. This allows for accurate representation of the shape of the ends of the slope areas 121 to 124 (i.e., the corners of the target shape 120).

The method for determining the endpoints of the line Lo is as follows. The recording point setting section 111 calculates the angle ω formed by the constituent lines La, La that constitute the outer periphery of the constituent surfaces S connected to each other in the surface area A, and determines whether the calculated angle ω is within the angle range (ω1 to ω2) that includes 180°. The recording point setting section 111 determines the connection point of the constituent lines La, La as the endpoint if the angle ω is outside the angle range. The recording point setting section 111 does not consider the connection point of the constituent lines La, La as the endpoint if the angle ω is within the angle range. In this case, the constituent lines La, La connected to each other are determined as the same outer peripheral line Lo. The threshold values ω1, ω2 that define the angle range are pre-stored in ROM 110b. ω1 is a value obtained by subtracting ω0 (e.g., about 5°) from 180°, and ω2 is a value obtained by adding ω0 to 180°.

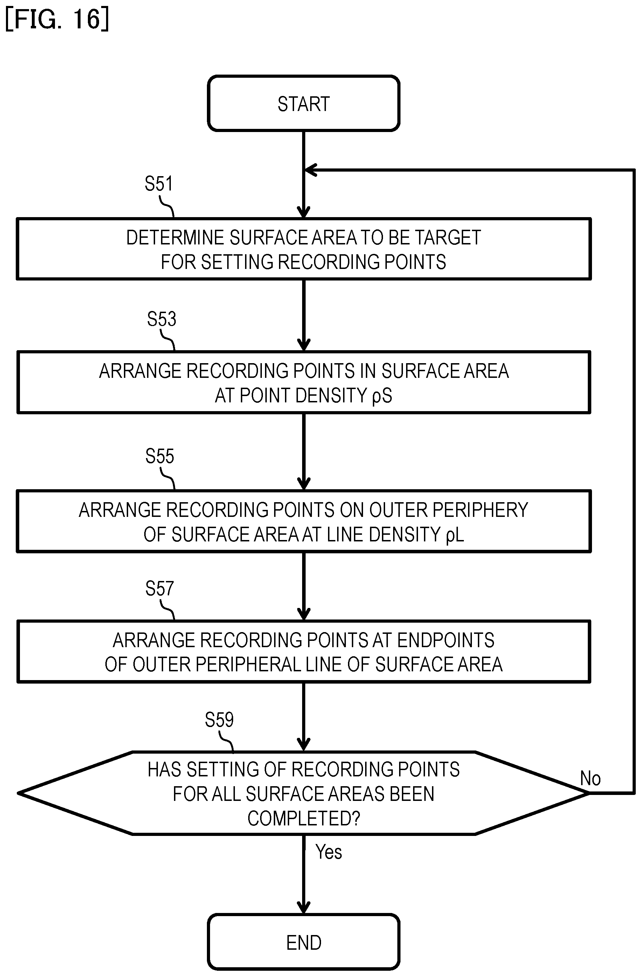

FIG. 16 is a diagram explaining the content of the recording point setting process by the recording point setting section 111. The process in the flowchart shown in FIG. 16 starts upon the completion of the flowchart shown in FIG. 13.

As shown in FIG. 16, in step S51, the recording point setting section 111 determines the initial surface area A to be the target for setting recording points and proceeds to step S53. In step S53, the recording point setting section 111 arranges recording points in the determined target surface area (also referred to as the target surface area) A at a predetermined point density ρS (see FIG. 14) and proceeds to step S55. In step S55, the recording point setting section 111 arranges recording points on the outer periphery of the target surface area A at a predetermined line density ρL (see FIG. 15A) and proceeds to step S57. In step S57, the recording point setting section 111 arranges recording points at the endpoints of the outer peripheral line Lo of the target surface area A (see FIG. 15B) and proceeds to step S59.

In step S59, the recording point setting section 111 determines whether the setting of recording points is complete for all surface areas A that constitute the target surface data. If it is determined in step S59 that the setting of recording points is not complete for all surface areas A that constitute the target surface data, the process returns to step S51. In step S51, the recording point setting section 111 determines the next surface area A to be the target for setting recording points from among the surface areas A where recording points have not been set, and proceeds to step S53. If it is determined in step S59 that the setting of recording points is complete for all surface areas A that constitute the target surface data, the recording point setting section 111 ends the process shown in the flowchart of FIG. 16.

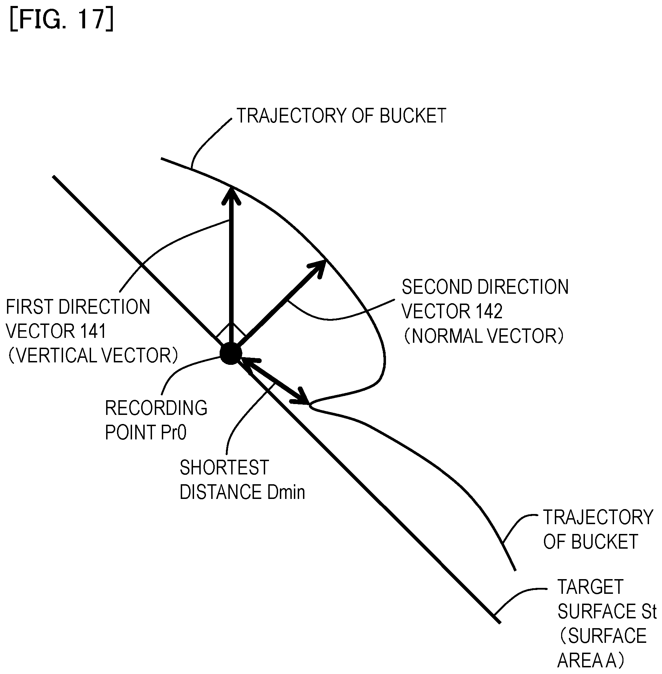

FIG. 17 is a diagram explaining the method for setting direction vectors by the recording point setting section 111, and also explains the recording points and the direction vectors set for the recording points. The direction vector is used in the construction history generation section 113, which will be described later, to calculate the position information (ENH coordinates) of the trajectory of the bucket 10 and the distance from the trajectory of the bucket 10 to the target surface St (target surface distance), etc. The distance from the trajectory of the bucket 10 to the target surface St is the straight-line distance between the recording point and the intersection of the straight line extending in the direction of the direction vector through the recording point and the surface constituting the trajectory of the bucket 10.

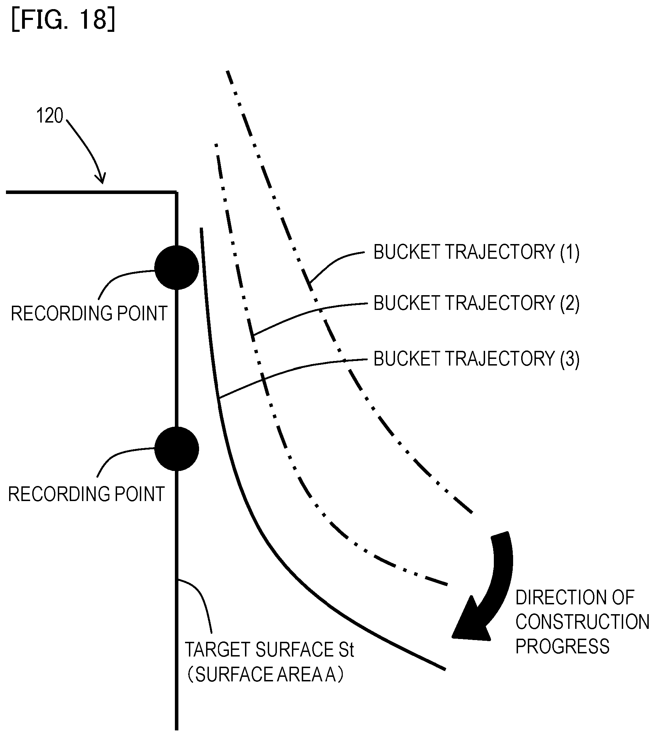

As shown in FIG. 17, the direction vector of a given recording point Pr0 can be a unit vector defined to extend vertically upward from the recording point Pr0 (hereinafter also referred to as the first direction vector 141). The first direction vector 141 is pre-stored in ROM 110b. By defining a unit vector extending vertically from the recording point as the direction vector in this way, it is possible to record the position information of the trajectory of the bucket 10 passing vertically above the recording point as construction history data. On the other hand, if a vector extending vertically from the recording point is defined as the direction vector, it may not be possible to appropriately record the position information of the trajectory of the bucket 10 passing laterally to the recording point. This will be explained in detail with reference to FIG. 18.

FIG. 18 is a diagram showing the progress of construction towards the vertical wall surface constituting the target shape 120. As shown in FIG. 18, if the target shape 120 includes a vertical wall surface (target surface St) consisting of a surface area A orthogonal to the reference plane (E-N plane), multiple recording points with the same E and N coordinates but different H coordinates are set on this vertical wall surface. As construction progresses towards the vertical wall surface in the order of the bucket trajectories (1), (2), and (3) shown in FIG. 18, the trajectory of the bucket 10 (i.e., the landscape) asymptotically approaches the vertical wall surface (target surface St). In such cases, if the direction vector is a vertically upward vector like the first direction vector 141 (see FIG. 17), there is a risk that construction history data cannot be recorded appropriately. Similarly, if the target shape 120 includes an overhang shape where the target surface protrudes outward as it goes upward from the reference plane, there is a risk that construction history data cannot be recorded appropriately. Therefore, it is desirable to set a direction vector with a horizontal component for the recording points of the surface area A of the vertical wall surface or overhang shape. In other words, it is preferable to change the orientation of the direction vector according to the inclination of the surface area A that constitutes the target surface data.

The recording point setting section 111 according to this embodiment, as shown in FIG. 17, calculates a unit vector extending in a direction orthogonal to the surface area A where the given recording point Pr0 is set as the second direction vector 142, and stores it in association with the recording point Pr0. In other words, the second direction vector 142 is a unit vector parallel to the normal vector of the surface area A to which the recording point belongs, and is directed in the opposite direction to the underground direction from the surface area A (i.e., towards the air or similar). The recording point setting section 111 calculates the normal vector for each surface area A and stores the unit vector of that normal vector as the second direction vector 142 in association with the recording points belonging to the surface area A. This allows for the appropriate recording of construction history data by the construction history generation section 113 when the target shape 120 includes vertical wall surfaces or overhang shapes. If the target shape 120 does not include vertical walls or overhang shapes, the recording point setting section 111 may use the first direction vector 141 to calculate the ENH coordinates of the trajectory of the bucket 10 and the target surface distance. In this case, the computational load can be reduced compared to when calculating the ENH coordinates of the trajectory of the bucket 10 and the target surface distance using the second direction vector 142.

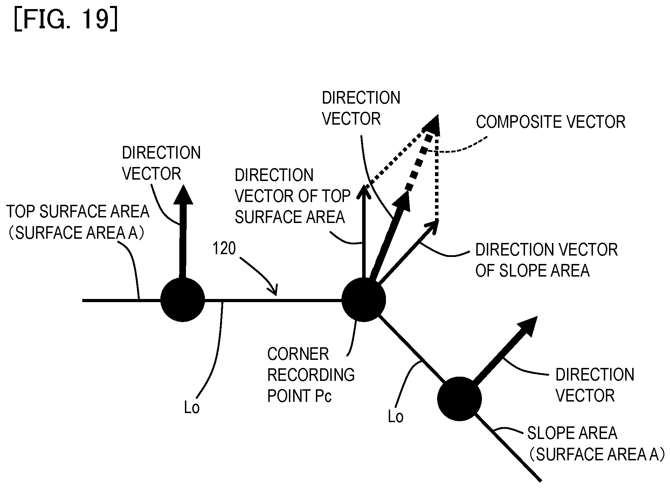

FIG. 19 is a diagram explaining the direction vector of the recording point Pc set at the corner of the target shape 120. As shown in FIG. 19, when a recording point Pc exists at a corner such as the shoulder or toe of a slope area, there are multiple surface areas A to which the recording point Pc belongs. In this case, any of the direction vectors of the surface area A to which the recording point Pc belongs may be adopted as the direction vector of the corner recording point Pc. Additionally, the unit vector of the composite vector of the direction vectors of at least two or more of the multiple surface areas A to which the recording point Pc belongs may be adopted as the direction vector of the corner recording point Pc.

Here, when the unit vector of the composite vector of the direction vectors of multiple surface areas A is adopted as the direction vector of the recording point Pc, the recording point setting section 111 may apply weighting to the direction vectors (unit vectors of the normal vectors) of each surface area A. The recording point setting section 111 according to this embodiment adopts the unit vector of the composite vector of all direction vectors with different directions among the direction vectors of the multiple surface areas A to which the recording point Pc belongs as the direction vector of the recording point Pc. This allows for accurate recording of the geographical features that asymptotically approaches the target surface St (surface area A) as construction progresses, regardless of the inclination of the target surface St (surface area A).

As shown in FIG. 17, if the computational capacity of the vehicle body controller 110 has room, the vehicle body controller 110 may acquire the position (ENH coordinates) with the shortest distance from the recording point among the trajectory of the bucket 10 that passed within a certain range of area during a certain period as the position information of the bucket 10's trajectory. In this case, the distance (shortest distance) Dmin from that position to the recording point is considered the distance (target surface distance) from the trajectory of the bucket 10 to the target surface St. Note that when acquiring the shortest position from the recording point as the position information of the bucket 10's trajectory, the direction vector changes due to the trajectory of the bucket 10, so the recording point setting section 111 cannot determine the direction vector. Therefore, when acquiring the shortest position from the recording point as the position information of the bucket 10's trajectory, the process of determining the direction vector by the recording point setting section 111 is omitted.

As described above, the recording point setting section 111 sets the coordinates of multiple recording points and sets the direction vector of each recording point based on the target surface data. The coordinates of the recording points may be ENH coordinates of the site coordinate system or coordinates of another coordinate system. Here, if there are no multiple recording points with the same E and N coordinates but different H coordinates (the combination of E and N coordinates of the recording points is unique), the recording point setting section 111 may calculate only the E and N coordinates of the recording points and omit the calculation of the H coordinates. Also, if the direction vector takes a constant value regardless of the recording point, the calculation process of the direction vector can be omitted.

In other words, the recording point setting section 111 may have a configuration that can set sufficient information to specify the recording points and direction vectors. The recording point setting section 111 may assign a unique ID to each recording point. In this case, the construction history generation section 113, which will be described later, omits the recording of recording points and direction vectors in the construction history data and records only the unique ID. In that case, the output section 154, which will be described later, needs to be configured to input or derive the combination of unique ID and recording point for each recording point, but it can reduce the capacity of the construction history data.

The trajectory calculation section 112 calculates the trajectory of the bucket 10 based on pressure information from the pressure detection device 162, operation information from the operation detection device 163, and posture information (angle information) from the posture detection device 130.

In the "excavation operation" where the bucket 10 excavates the ground, the trajectory of the bucket 10 is the movement trajectory of the tip of the bucket 10 in contact with the ground. In the "compaction operation" where the ground is compacted by moving the bucket 10 forward, the trajectory of the bucket 10 is the movement trajectory of a specific part on the back of the bucket 10 in contact with the ground. In the "slope tamping operation" where the bucket 10 is slammed into the ground, the trajectory of the bucket 10 corresponds to the bottom surface of the bucket 10 at the moment it is slammed into the ground.

In the compaction operation, the "specific part on the back of the bucket 10" in contact with the ground varies depending on the shape of the bucket 10. For example, in a bucket like a slope finishing bucket, where the back and bottom surfaces of the bucket are not smoothly connected, it is preferable to set the opposite end to the tip on the bottom surface of the bucket as the specific part on the back. On the other hand, for a general bucket where the back and bottom surfaces are smoothly connected and the back of the bucket 10 is curved, the part in contact with the ground varies depending on the shape of the bucket 10. Therefore, it is preferable to experimentally perform the compaction operation before work, confirm the part where the bucket 10 contacts the ground, and set the specific part on the back of the bucket 10.

The trajectory calculation section 112 determines whether the hydraulic excavator 100 is performing an excavation operation based on operation information from the operation detection device 163 and pressure information from the pressure detection device 162. In the excavation operation, the arm roll-in operation is performed, and the bucket 10 is in contact with the ground.

The trajectory calculation section 112 determines that the arm roll-in operation is being performed if the arm roll-in operation amount of the left control lever device 22b is equal to or greater than the predetermined operation amount threshold La1, and determines that the arm roll-in operation is not being performed if the arm roll-in operation amount is less than the operation amount threshold La1. The operation amount threshold La1 is a threshold for determining whether the left control lever device 22b is operated in the arm roll-in direction, and is stored in advance in ROM 110b.

The trajectory calculation section 112 determines that the bucket 10 is in contact with the ground if the pressure Pab of the bottom-side oil chamber of the arm cylinder 6 is equal to or greater than the pressure threshold Pab0, and determines that the bucket 10 is not in contact with the ground if the pressure Pab of the bottom-side oil chamber of the arm cylinder 6 is less than the pressure threshold Pab0. The pressure threshold Pab0 is a threshold for determining whether the bucket 10 is in contact with the ground during the excavation operation by the arm roll-in operation, and is stored in advance in ROM 110b. When the arm cylinder 6 operates in the direction of extension, the pressure in the bottom-side oil chamber of the arm cylinder 6 increases when the bucket 10 contacts the ground. Therefore, by monitoring the pressure in the bottom-side oil chamber of the arm cylinder 6, it is possible to determine whether the excavation operation is being performed.

The trajectory calculation section 112 determines that the hydraulic excavator 100 is performing an excavation operation if the arm roll-in operation amount of the left control lever device 22b is equal to or greater than the operation amount threshold La1, and the pressure Pab of the bottom-side oil chamber of the arm cylinder 6 is equal to or greater than the pressure threshold Pab0. The trajectory calculation section 112 determines that the hydraulic excavator 100 is not performing an excavation operation if the arm roll-in operation amount of the left control lever device 22b is less than the operation amount threshold La1, or if the pressure Pab of the bottom-side oil chamber of the arm cylinder 6 is less than the pressure threshold Pab0.

The trajectory calculation section 112 determines whether the hydraulic excavator 100 is performing a compaction operation based on operation information from the operation detection device 163 and pressure information from the pressure detection device 162. In the compaction operation, the arm extend operation is performed, and the bucket 10 is in contact with the ground.

The trajectory calculation section 112 determines that the arm extend operation is being performed if the arm extend operation amount of the left control lever device 22b is equal to or greater than the predetermined operation amount threshold La2, and determines that the arm extend operation is not being performed if the arm extend operation amount is less than the operation amount threshold La2. The operation amount threshold La2 is a threshold for determining whether the left control lever device 22b is operated in the arm extend direction, and is stored in advance in ROM 110b.

The trajectory calculation section 112 determines that the bucket 10 is in contact with the ground if the pressure Par of the rod-side oil chamber of the arm cylinder 6 is equal to or greater than the pressure threshold Par0, and determines that the bucket 10 is not in contact with the ground if the pressure Par of the rod-side oil chamber of the arm cylinder 6 is less than the pressure threshold Par0. The pressure threshold Par0 is a threshold for determining whether the bucket 10 is in contact with the ground during the compaction operation by the arm extend operation, and is stored in advance in ROM 110b. When the arm cylinder 6 operates in the direction of retraction, the pressure in the rod-side oil chamber of the arm cylinder 6 increases when the bucket 10 contacts the ground. Therefore, by monitoring the pressure in the rod-side oil chamber of the arm cylinder 6, it is possible to determine whether the compaction operation is being performed.

The trajectory calculation section 112 determines that the hydraulic excavator 100 is performing a compaction operation if the arm push operation amount of the left control lever device 22b is equal to or greater than the operation amount threshold La2, and the pressure Par of the rod-side oil chamber of the arm cylinder 6 is equal to or greater than the pressure threshold Par0. The trajectory calculation section 112 determines that the hydraulic excavator 100 is not performing a compaction operation if the arm push operation amount of the left control lever device 22b is less than the operation amount threshold La2, or if the pressure Par of the rod-side oil chamber of the arm cylinder 6 is less than the pressure threshold Par0.

The trajectory calculation section 112 determines whether the hydraulic excavator 100 is performing a slope tamping operation based on the operation information from the operation detection device 163 and the pressure information from the pressure detection device 162. In the slope tamping operation, the boom lowering operation is performed, and the bucket 10 contacts and presses the ground.

The trajectory calculation section 112 determines that the boom lowering operation is being performed if the boom lowering operation amount of the right control lever device 22a is equal to or greater than the predetermined operation amount threshold Lb1, and determines that the boom lowering operation is not being performed if the boom lowering operation amount is less than the operation amount threshold Lb1. The operation amount threshold Lb1 is a threshold for determining whether the right control lever device 22a is being operated in the boom lowering direction, and is stored in advance in ROM 110b.

The trajectory calculation section 112 determines that the bucket 10 is contacting and pressing the ground if the pressure Pbr of the rod-side oil chamber of the boom cylinder 5 is equal to or greater than the pressure threshold Pbr0, and determines that the bucket 10 is not pressing the ground if the pressure Pbr is less than the pressure threshold Pbr0. The pressure threshold Pbr0 is a threshold for determining whether the bucket 10 is pressing the ground during the slope tamping operation by the boom lowering operation, and is stored in advance in ROM 110b. When the boom cylinder 5 operates in the direction of contraction, and the bucket 10 is pressed against (or slammed into) the ground, the pressure in the rod-side oil chamber of the boom cylinder 5 rises sharply. Therefore, by monitoring the pressure in the rod-side oil chamber of the boom cylinder 5, it is possible to determine whether the slope tamping operation is being performed.

The trajectory calculation section 112 determines that the hydraulic excavator 100 is performing a slope tamping operation if the boom lowering operation amount of the right control lever device 22a is equal to or greater than the operation amount threshold Lb1, and the pressure Pbr of the rod-side oil chamber of the boom cylinder 5 is equal to or greater than the pressure threshold Pbr0. The trajectory calculation section 112 determines that the hydraulic excavator 100 is not performing a slope tamping operation if the boom lowering operation amount of the right control lever device 22a is less than the operation amount threshold Lb1, or if the pressure Pbr of the rod-side oil chamber of the boom cylinder 5 is less than the pressure threshold Pbr0.

It should be noted that the methods for determining excavation operations, compaction operations, and slope tamping operations are not limited to the methods described above. The trajectory calculation section 112 may determine the operation based on only one of the operation information from the operation detection device 163 or the pressure information from the pressure detection device 162. For example, the trajectory calculation section 112 may determine that a slope tamping operation is being performed if the rate of change over time of the pressure Pbr in the rod-side oil chamber of the boom cylinder 5 is equal to or greater than a threshold, and may determine that a slope tamping operation is not being performed if the rate of change is less than the threshold.

The trajectory calculation section 112 executes the trajectory calculation process when it is determined that any of the excavation operation, compaction operation, or slope tamping operation is being performed. The trajectory calculation process will be described in detail below.

The trajectory calculation section 112 repeatedly calculates the position coordinates (position information) of the monitor points set on the bucket 10 at a predetermined calculation cycle, thereby calculating the trajectory (trajectory data) of the bucket 10 composed of the position coordinates of the monitor points at each time. By connecting the position coordinates of the monitor points in a time series, the surface constituting the trajectory of the bucket 10 is identified.

The monitor point is a point for identifying the trajectory of the part where the bucket 10 is in contact with the ground while the working device 100a is performing work, and is set according to the operation content (work content) of the hydraulic excavator 100. If it is determined that an excavation operation is being performed, the trajectory calculation section 112 sets the two points at the left and right ends of the tip Pb of the bucket 10 as monitor points. If it is determined that a compaction operation is being performed, the trajectory calculation section 112 sets the two points at the left and right ends of a specific part of the back of the bucket 10 as monitor points. If it is determined that a slope tamping operation is being performed, the trajectory calculation section 112 sets the points at the four corners of the bottom surface of the bucket 10 as monitor points.

The trajectory calculation section 112 calculates the position coordinates of the monitor points in the site coordinate system at predetermined time intervals (calculation cycles) based on the posture information (boom angle $\alpha$, arm angle $\beta$, bucket angle $\gamma$, antenna position coordinates in the site coordinate system of the first GNSS antenna 35a, and the azimuth angle $\theta y$, roll angle $\theta r$, and pitch angle $\theta p$ of the vehicle body 100b (swing body 12)) output by the posture detection device 130, and the dimension information of each part of the hydraulic excavator 100 stored in ROM 110b. The position coordinates of the monitor points calculated at each predetermined time represent the trajectory of the bucket 10. In other words, the trajectory calculation section 112 calculates the trajectory of the bucket 10 based on the posture information and dimension information of the hydraulic excavator 100.

Figure 6 is a diagram illustrating a specific calculation method for the position coordinates of the monitor points when an excavation operation is being performed, showing the shovel reference coordinate system. The shovel reference coordinate system in Figure 6 is a coordinate system set with respect to the swing body 12. In the shovel reference coordinate system, the center of the left and right width of the boom pin 91 on its central axis is set as the origin O. In the shovel reference coordinate system, an axis parallel to the central axis of rotation of the swing body 12 and extending upward from the origin O is set as the Z-axis. In the shovel reference coordinate system, an axis orthogonal to the Z-axis and extending forward from the origin O is set as the X-axis. In the shovel reference coordinate system, an axis orthogonal to the Z-axis and X-axis and extending to the left from the origin O is set as the Y-axis. In other words, the central axis of the boom pin 91 extending in the left-right direction of the swing body 12 is set as the Y-axis.

The inclination angle of the boom 8 with respect to the X-Y plane is the boom angle $\alpha$, the inclination angle of the arm 9 with respect to the boom 8 is the arm angle $\beta$, and the inclination angle of the bucket 10 with respect to the arm 9 is the bucket angle γ. The boom angle α is the minimum when the boom 8 is raised to the upper limit (boom cylinder 5 is in the fully extended state) and the maximum when the boom 8 is lowered to the lower limit (boom cylinder 5 is in the fully contracted state). The arm angle β is the minimum when the arm cylinder 6 is in the fully contracted state and the maximum when the arm cylinder 6 is in the fully extended state. The bucket angle γ is the minimum when the bucket cylinder 7 is in the fully contracted state (the state in Figure 6) and the maximum when the bucket cylinder 7 is in the fully extended state. Additionally, the inclination angle of the vehicle body 100b (swing body 12) around the Y-axis is the pitch angle θp, the inclination angle around the X-axis is the roll angle θr, and the inclination angle around the Z-axis is the azimuth angle θy.

By using the azimuth angle θy, pitch angle θp, and roll angle θr, as well as the coordinates of the first GNSS antenna 35a in the shovel reference coordinate system and the coordinates in the site coordinate system obtained by RTK-GNSS positioning of the first GNSS antenna 35a, the vehicle body coordinate system and the site coordinate system can be mutually converted.

The position coordinates of the monitor points in the site coordinate system are obtained by converting the position coordinates in the shovel reference coordinate system calculated from the rotation angles α, β, γ of the boom 8, arm 9, and bucket 10, and the dimension information of the working device 100a.

The Z and X coordinates of the monitor point (in the example shown in Figure 6, the tip of the bucket 10) Pb in the shovel reference coordinate system can be expressed by the following equations (1) and (2).

[Math. 1]

$$Z = L_{bm} \cdot \sin\alpha + L_{am} \cdot \sin(\alpha + \beta) + L_{bkt} \cdot \sin(\alpha + \beta + \gamma) \quad \cdots \quad (1)$$

[Math. 2]

$$X = L_{bm} \cdot \cos\alpha + L_{am} \cdot \cos(\alpha + \beta) + L_{bkt} \cdot \cos(\alpha + \beta + \gamma) \quad \cdots \quad (2)$$

The Y coordinate of the monitor point, which is the tip Pb of the bucket 10, can be determined from the Y-axis offset amount (a constant value) Yo from the origin O to the center in the width direction of the bucket 10 and the width of the tip of the bucket 10. For example, if the width of the tip Pb of the bucket 10 is bw, the Y coordinates of the monitor points are Yo-(bw/2) and Yo+(bw/2). The offset amount Yo is stored in advance in ROM 110b. If the Y coordinate of the center in the width direction of the bucket 10 is 0 (zero), the Y coordinates of the monitor points are (-bw/2) and (+bw/2).

Let the vector from the first GNSS antenna 35a in the shovel reference coordinate system to the origin of the shovel reference coordinate system be (offset_X, offset_Y, offset_Z), the rotation matrices around the X, Y, Z axes in the shovel reference coordinate system be Rx(θr), Ry(θp), Rz(θy), the position coordinates of the monitor point in the shovel reference coordinate system be (X, Y, Z), and the position vector from the origin of the site coordinate system to the position coordinates of the first GNSS antenna 35a be (E_GNSS, N_GNSS, H_GNSS). Then, the position coordinates (E, N, H) of the monitor point in the site coordinate system, i.e., the ENH coordinates, are calculated by the following equation (3).

[Math. 3]

$$\begin{pmatrix} E \\ N \\ H \end{pmatrix} = Rx(\theta_r) \cdot Ry(\theta_p) \cdot Rz(\theta_y) \left( \begin{pmatrix} offset\_X \\ offset\_Y \\ offset\_Z \end{pmatrix} + \begin{pmatrix} X \\ Y \\ Z \end{pmatrix} \right) + \begin{pmatrix} E\_GNSS \\ N\_GNSS \\ H\_GNSS \end{pmatrix} \quad \cdots \quad (3)$$

The construction history generation section 113 shown in FIG. 5 generates construction history data based on the coordinates and direction vectors of the recording points calculated by the recording point setting section 111 and the trajectory of the bucket 10 (monitor point trajectory) calculated by the trajectory calculation section 112. The construction history generation section 113 calculates the position information of the trajectory of the bucket 10 as construction history data by associating the position coordinates (position information) of the monitor points constituting the trajectory of the bucket 10 with each of the multiple recording points using a predetermined method. The construction history generation section 113 records the generated construction history data in the storage device 169.

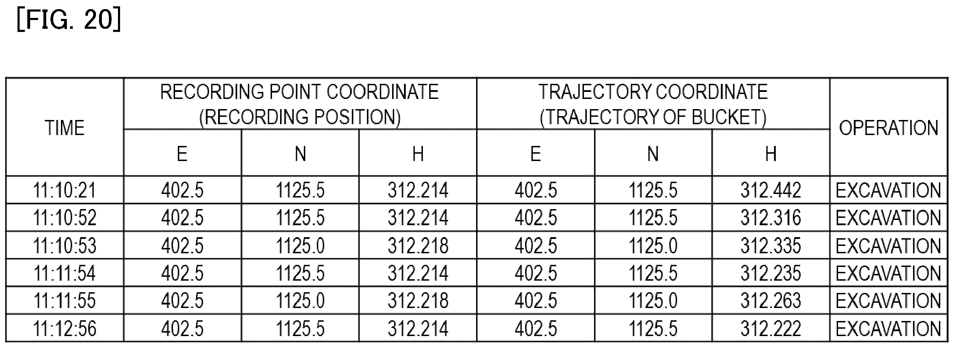

FIG. 20 is a diagram showing an example of a construction history data table. As shown in FIG. 20, the construction history data table is a collection of log data recorded with time (timestamp). The log data of the construction history data table shown in FIG. 20 includes the ENH coordinates (also referred to as recording point coordinates) as information of the recording points, the ENH coordinates (also referred to as trajectory coordinates) as position information of the trajectory of the bucket 10 that passed near the recording point, and the operation determination result by the trajectory calculation section 112.

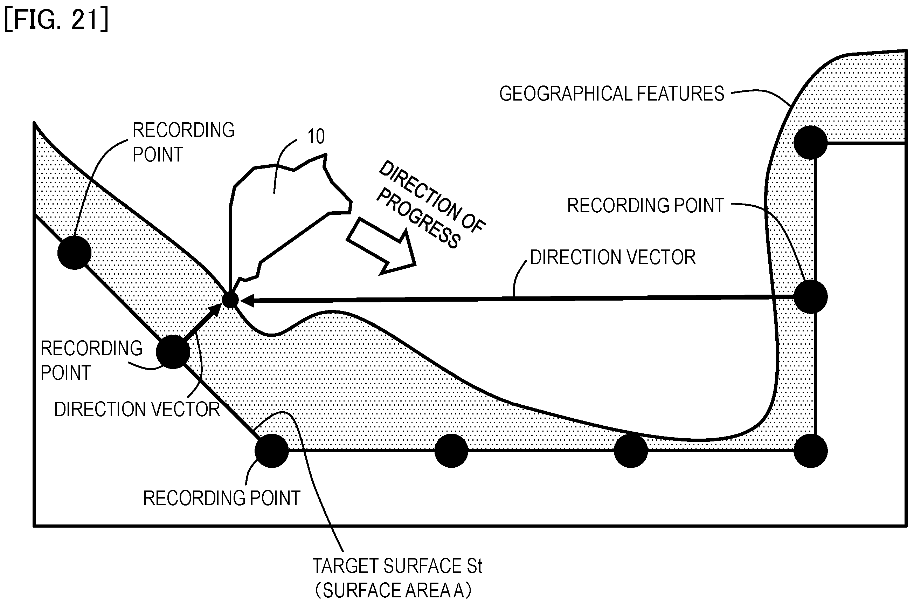

FIG. 21 is a diagram explaining the method of calculating the trajectory coordinates of the bucket 10 as construction history data. In this embodiment, as shown in FIG. 21, the construction history generation section 113 calculates the ENH coordinates of the intersection of the straight line extending in the direction of the direction vector passing through the recording point and the surface constituting the trajectory of the bucket 10 as the trajectory coordinates. The construction history generation section 113 records the calculated trajectory coordinates in the construction history data table. In other words, in this embodiment, construction history data is calculated by associating the position information of the monitor points constituting the trajectory of the bucket 10 with multiple recording points using a method that employs direction vectors extending from the recording points.

However, in the example shown in FIG. 21, depending on the position and direction vector of the recording point, such as a recording point set on a vertical wall surface, the straight line extending in the direction of the direction vector passing through the recording point and the trajectory of the bucket 10 may intersect at a position far from the geographical features. Therefore, in this embodiment, the construction history generation section 113 calculates the distance in the direction of the direction vector from the recording point to the trajectory of the working device 100a (i.e., the target surface distance, which is the distance from the trajectory of the bucket 10 to the recording point) D. If the calculated target surface distance D is greater than or equal to the distance threshold D0, the position information of the trajectory of the working device 100a associated with the recording point is not recorded as construction history data. The construction history generation section 113 records the ENH coordinates, which are the position information of the trajectory of the working device 100a associated with the recording point, as construction history data if the calculated target surface distance D is less than the distance threshold D0. The distance threshold D0 is a constant value, for example, about 1m, and is stored in advance in ROM 110b.

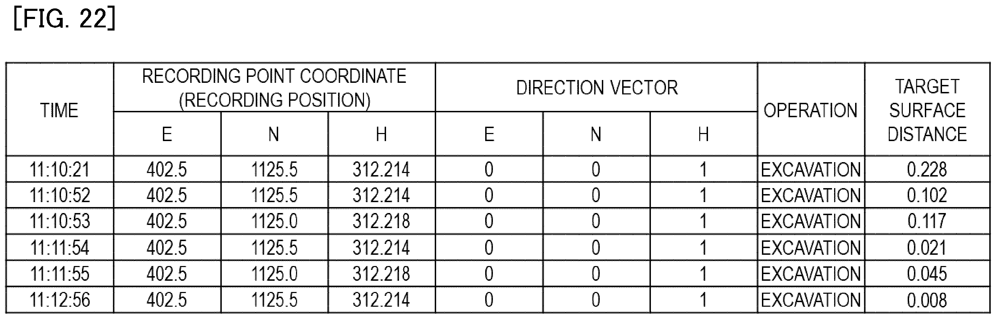

FIG. 22 is a diagram showing another example of a construction history data table. As shown in FIG. 22, the log data of the construction history data table includes the ENH coordinates (recording point coordinates) of the recording points, the distance in the direction of the direction vector from the recording point to the trajectory of the bucket 10 (i.e., the target surface distance, which is the distance from the trajectory of the bucket 10 to the target surface St) D, the direction vector used in the calculation of the target surface distance D, and the operation determination result by the trajectory calculation section 112.

The target surface distance D is, as described above, the straight-line distance from the intersection of the straight line extending in the direction of the direction vector passing through the recording point and the surface constituting the trajectory of the bucket 10 to the recording point. The target surface distance D takes a positive value if the trajectory of the bucket 10 is in the direction of the direction vector (aerial or ground direction) from the target surface St, and a negative value if the trajectory of the bucket 10 is in the opposite direction of the direction vector (toward the ground) from the target surface St.

In this way, the construction history generation section 113 may calculate the ENH coordinates of the trajectory of the bucket 10 and record the calculated ENH coordinates of the trajectory of the bucket 10 itself as construction history data (see FIG. 20). Alternatively, the ENH coordinates of the recording points, the direction vector, and the target surface distance D necessary to specify the ENH coordinates of the trajectory of the bucket 10 may be calculated, and the calculation results may be recorded as construction history data (see FIG. 22).

Note that the ENH coordinates of the trajectory of the bucket 10 (see FIG. 20) and the direction vector (see FIG. 22) are parameters associated with the recording points. Therefore, if a unique ID is assigned to each recording point, the capacity of the construction history data may be reduced by recording the ID of the recording point instead of the ENH coordinates of the recording point. Additionally, if there is duplicate information in the construction history data table, such as when multiple log data have the same timestamp, the data amount may be reduced by making the log data variable in length. Furthermore, if a fixed value such as (0,0,1) is always used for the direction vector, and the direction vector can be determined post-process by matching the coordinates of the recording points with the target surface data, or if the direction vector is not used, unnecessary information or information that can be derived from other parameters need not be recorded as construction history data.

The transmission section 114 shown in FIG. 5 transmits the log data of the construction history data generated by the construction history generation section 113 and stored in the storage device 169 to the management controller 150. In other words, the vehicle controller 110, which constitutes the construction history calculation system 181, outputs the log data of the construction history data stored in the storage device 169 to the management controller 150, which constitutes the terrain data calculation system 182.

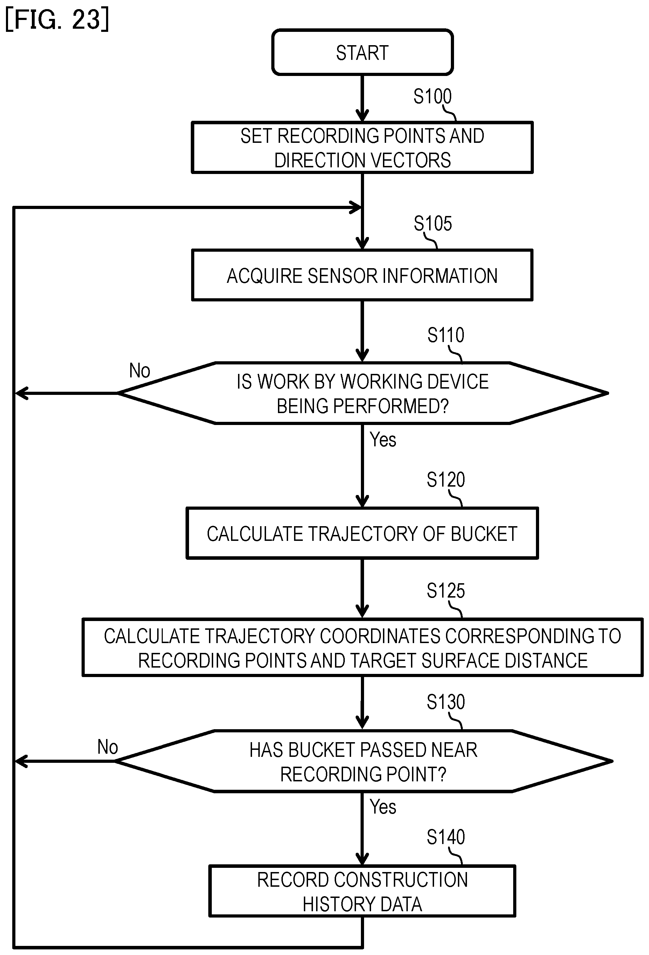

FIG. 23 is a diagram explaining the construction history data generation process executed by the vehicle controller 110. The process of the flowchart shown in FIG. 23 is started, for example, by turning on the ignition switch (not shown). After the setting process of the recording points of the trajectory in step S100 is performed, the processes from step S105 to S140 are repeatedly executed at a predetermined calculation cycle.

As shown in FIG. 23, in step S100, the vehicle controller 110 (recording point setting section 111) sets the coordinates and direction vector of the recording points based on the target surface data input from the target surface input device 161, and proceeds to step S105. The specific processing content of step S100 has been explained with reference to FIGS. 13 and 16, so the explanation here is omitted. In step S105, the vehicle controller 110 (trajectory calculation section 112) acquires sensor information such as operation information (operation direction and operation amount) detected by the operation detection device 163, posture information (position coordinates of the hydraulic excavator 100, boom angle $\alpha$, arm angle $\beta$, bucket angle $\gamma$, pitch angle $\theta p$, roll angle $\theta r$, and azimuth angle $\theta y$) detected by the posture detection device 130, and pressure information detected by the pressure detection device 162, and proceeds to step S110.

In step S110, the vehicle controller 110 (trajectory calculation section 112) executes an operation determination process to determine whether any of the excavation operation, compaction operation, and slope tamping operation is being performed based on the operation information and pressure information acquired in step S105. In step S110, if it is determined that any of the excavation operation, compaction operation, and slope tamping operation is being performed, it is assumed that work is being performed by the working device 100a, and the process proceeds to step S120. In step S110, if it is determined that none of the excavation operation, compaction operation, and slope tamping operation is being performed, the process returns to step S105.

In step S120, the vehicle controller 110 (trajectory calculation section 112) calculates the trajectory of the bucket 10 (position coordinates of the monitor point) and proceeds to step S125. In step S125, the vehicle controller 110 (construction history generation section 113) calculates the coordinates of the intersection (trajectory coordinates corresponding to the recording point) of the straight line extending in the direction of the direction vector passing through the recording point and the surface constituting the trajectory of the bucket 10, and the target surface distance D, based on the trajectory of the bucket 10 calculated in step S120 and the recording point and direction vector set in step S100, and proceeds to step S130. If there is no intersection between the straight line extending in the direction of the direction vector passing through the recording point and the surface constituting the trajectory of the bucket 10, a predetermined invalid value is set for the target surface distance D. The invalid value is a value greater than the distance threshold D0 and is stored in advance in ROM 110b.

In step S130, the vehicle controller 110 (construction history generation section 113) determines whether the bucket 10 has passed near the recording point. In step S130, the vehicle body controller 110 determines that the bucket 10 has passed near the recording point corresponding to the target surface distance D calculated in step S125 if the target surface distance D is less than the distance threshold D0, and proceeds to step S140. In step S130, if the target surface distance D associated with all recording points calculated in step S125 is equal to or greater than the distance threshold D0, the vehicle body controller 110 determines that the bucket 10 has not passed near the recording point and returns to step S105.

In step S140, the vehicle body controller 110 records the ENH coordinates of the recording point determined in step S130 to have been passed by the bucket 10, the ENH coordinates of the trajectory corresponding to that recording point, the target surface distance, and the operation content as construction history data in the storage device 169 along with the time (timestamp) in this calculation cycle, and returns to step S105.

By repeatedly executing the processes of steps S105 to S140 shown in the flowchart of FIG. 23, the log data of the construction history data is accumulated in the storage device 169. The log data of the construction history data accumulated in the storage device 169 is transmitted to the management server 51 at a predetermined transmission cycle.

As shown in FIG. 5, the management controller (second processing device) 150 of the management server 51 receives the construction history data transmitted from the vehicle body controller 110 of the hydraulic excavator 100 and executes a process to generate terrain data based on the position information of the trajectory of the bucket 10 included in the received construction history data. The functions of the management controller 150 will be described in detail below.

The management controller 150 functions as a receiving section 151, an extraction section 152, and an output section 154. The receiving section 151 receives the construction history data transmitted from the vehicle body controller 110 of the hydraulic excavator 100 and stores the received log data of the construction history data in the storage device 52.

The receiving section 151 accumulates the log data of the construction history data output by a specific hydraulic excavator 100 in the storage device 52. The receiving section 151 may also accumulate construction history data output by multiple hydraulic excavators 100 in the storage device 52.

When the log data of the construction history data is accumulated in the storage device 52, there may be log data within it where the construction areas overlap. The extraction section 152 estimates and extracts from the log data of the construction history data stored in the storage device 52 those where the trajectory of the bucket 10 is close to the geographical features. In other words, if the construction history data is obtained from excavation or compaction operations, the extraction section 152 extracts the log data when it is estimated that the bucket 10 moved along the geographical features. Hereinafter, the log data extracted by the extraction section 152 is also referred to as extracted log data.

The extraction section 152 determines whether the construction areas overlap in the log data of the construction history data stored in the storage device 52 (i.e., whether there are two or more identical log data for the corresponding recording point).

In this embodiment, the extraction section 152 determines that the construction areas overlap if there are multiple timestamp log data for the same recording point. The extraction section 152 estimates and extracts the log data that is

EP 4 585 756 A1

closest to the geographical features from the log data determined to have overlapping construction areas, such as those where the combination of E and N coordinates of the trajectory's ENH coordinates overlaps with other log data, based on extraction conditions.

The extraction section 152 determines that the construction areas do not overlap if there is log data for recording points that are not the same as other recording points. The extraction section 152 adopts the log data determined not to have overlapping construction areas as extracted log data as is.

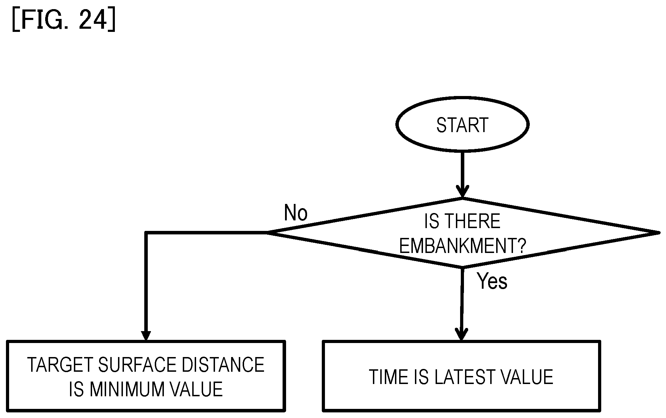

FIG. 24 is a diagram explaining an example of setting extraction conditions for the log data of construction history data. As shown in FIG. 24, if there is no embankment portion at the site in the log data of the construction history data (only cut exists), it is considered that the height of the geographical features will always change in a downward direction, so it is preferable to adopt the extraction condition of ""target surface distance is the minimum value"". In this case, among the log data with overlapping construction areas, the one with the minimum target surface distance D is extracted as extracted log data. If there is an embankment portion at the site in the log data of the construction history data, it is assumed that the height of the geographical features will increase or decrease, so it is preferable to use the extraction condition ""time is the latest value"" using time information rather than height direction conditions. In this case, among the log data with overlapping construction areas, the one with the latest time is extracted as extracted log data.

The output section 154 shown in FIG. 5 converts the log data extracted by the extraction section 152 into point cloud data or TIN (Triangulated Irregular Network) data and outputs the converted data as current terrain data to the progress management system 190.

The progress management system 190 calculates progress management information such as volume and final shape based on the current terrain data generated by the management controller 150. The progress management system 190 outputs the progress management information to the display device 53 (see FIGS. 1 and 4) and presents information to the administrator by displaying the progress management information on the display screen of the display device 53. It should be noted that the method of information presentation is not limited to this. The progress management system 190 may output the progress management information to a printing device (not shown) and have the printing device print the progress management information on paper media.

Additionally, the progress management system 190 may display the progress management information on the display screen of the display device 164 mounted on the hydraulic excavator 100 (see FIG. 4), or on the display screens of mobile devices such as smartphones, tablets, and notebook PCs carried by workers operating around the hydraulic excavator 100. The functions of the progress management system 190 may be provided by the management controller 150.

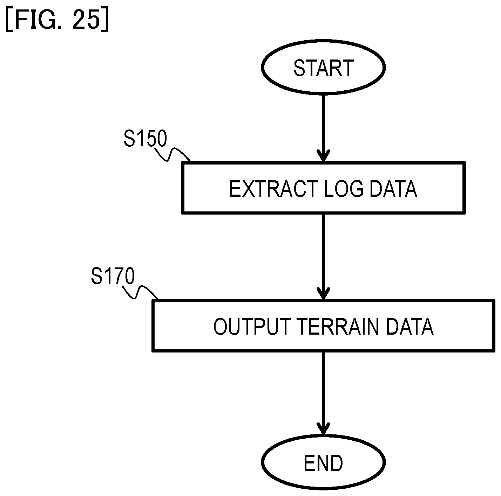

FIG. 25 is a diagram explaining the terrain data generation and output processing executed by the management controller 150. The process in the flowchart shown in FIG. 25 is initiated by the execution operation of the terrain data generation and output processing by the input device 54 of the management server 51, and is executed after initial settings (not shown) are made.

In step S150, the management controller 150 extracts the extracted log data from the log data of the construction history data stored in the storage device 52 based on extraction conditions and proceeds to step S170.

In step S170, the management controller 150 converts the log data extracted in step S150 into point cloud data or TIN data, outputs the converted data as current terrain data to the progress management system 190, and ends the process shown in the flowchart of FIG. 24.

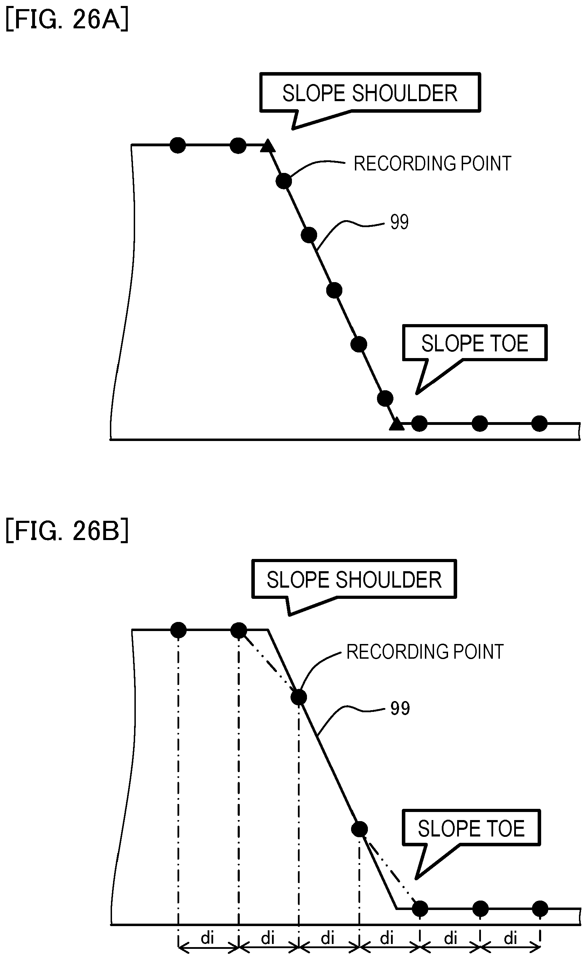

FIGS. 26A and 26B are diagrams explaining the differences between the terrain data generated by the terrain data generation system 180 according to this embodiment and the terrain data generated by the terrain data generation system according to a comparative example of this embodiment. FIG. 26A is a diagram showing the terrain data generated by the terrain data generation system 180 according to this embodiment. FIG. 26B is a diagram showing the terrain data generated by the terrain data generation system according to a comparative example of this embodiment.

The terrain data generation system according to a comparative example of this embodiment generates terrain data based on recording points arranged at a constant interval di on the E-N plane, as shown in FIGS. 7, 8, and 26B. In other words, in the terrain data generation system according to a comparative example of this embodiment, the point density of recording points in the slope areas 121 to 124 is smaller than that in the top surface area 125. Therefore, in the terrain data generation system according to a comparative example of this embodiment, as shown by the two-dot chain line in FIG. 26B, it may not be possible to accurately reproduce the geographical features 99 of characteristic parts such as the slope shoulder and slope toe.

In contrast, in the terrain data generation system 180 according to this embodiment, as shown in FIGS. 10 and 26A, recording points are set in the slope areas 121 to 124 so that the point density of recording points in the slope areas 121 to 124 is approximately the same as the point density of recording points in the top surface area 125. Therefore, in this embodiment, it is possible to reproduce the geographical features 99 of characteristic parts such as the slope shoulder and slope toe more accurately than in the comparative example. Additionally, as shown in FIG. 15A, by placing recording points (triangle mark ▲) on the outer periphery of each surface area A constituting the target shape 120, it is possible to reproduce the geographical features 99 of characteristic parts such as the slope shoulder and slope toe more accurately.

Furthermore, as shown in FIG. 15B, by placing recording points (see star mark ★) at the endpoints of the outer boundary line Lo of each surface area A constituting the target shape 120, it is possible to accurately reproduce the corners of the geographical features 99.

According to the above-described embodiment, the following effects are achieved.

(1) The construction history calculation system 181 includes a vehicle body controller (controller) 110 that calculates construction history data based on the detection results of the posture detection device 130 that detects the posture of the hydraulic excavator (work machine) 100. The vehicle body controller 110 acquires target surface data and sets multiple recording points so that the predetermined point density $\rho S$ is achieved for the surface area A constituting the target surface data based on the acquired target surface data. Note that the surface area A is composed of one or more constituent surfaces S. For example, the vehicle body controller 110 considers multiple constituent surfaces that make up the target surface data (including the target constituent surface and adjacent constituent surfaces) as the surface area A. The vehicle body controller 110 calculates the trajectory of the working device 100a of the hydraulic excavator 100 based on the detection results of the posture detection device 130. The vehicle body controller 110 calculates the position information of the trajectory of the working device 100a, which is associated with the position information of the monitor points of the working device 100a that constitute the trajectory, as construction history data. The position information of the trajectory of the working device 100a may be the coordinates of the monitor points' trajectory itself as shown in FIG. 20, or as shown in FIG. 22, it may be information to specify the coordinates of the monitor points' trajectory, namely the coordinates of the recording points, direction vectors, and target surface distance.

In this configuration, recording points can be arranged in the surface area A with an appropriate point density. In this embodiment, for example, as shown in FIG. 10, the point density of the recording points set in the slope areas 121 to 124 can be made approximately the same as the point density of the recording points set in the top surface area 125. That is, the construction history calculation system 181 can generate and output construction history data based on recording points with appropriately set point density. Therefore, the terrain data calculation system 182 can generate highly accurate terrain data. In other words, according to this embodiment, it is possible to provide a construction history calculation system 181 that can calculate the construction history data necessary for generating highly accurate terrain data and output the calculated construction history data to the terrain data calculation system 182.

(2) The terrain data generation system 180 includes a construction history calculation system 181 and a terrain data calculation system 182 that calculates terrain data indicating the final shape by the working device 100a of the hydraulic excavator (work machine) 100 based on the position information of the trajectory of the working device 100a included in the construction history data. Therefore, according to this embodiment, it is possible to provide a terrain data generation system 180 capable of generating highly accurate terrain data.

(3) When the surface area A is set as shown in FIGS. 9 and 10, the vehicle body controller 110 sets recording points so that a constant point density is achieved for all the constituent surfaces (top surface area 125, slope areas 121 to 124) that make up the target surface data. For example, when the surface area A (first surface area A1) is set as shown in FIG. 11, the vehicle body controller 110 sets recording points so that a constant point density is achieved for all surface areas A (A1, A2...) that make up the target surface data. Similarly, when the surface area A is set as shown in FIG. 14, the vehicle body controller 110 sets recording points for surface areas A11, A12, A13, A14, A15 so that each has the same point density $\rho S$. As a result, the construction history calculation system 181 can output the construction history data necessary for generating terrain data with uniform accuracy.

(4) The target surface data is data that defines the target shape 120 with multiple constituent surfaces S. The vehicle body controller 110 sets the target constituent surface and the adjacent constituent surface as the same surface area (for example, the surface area A1 shown in FIG. 11) if the angle $\varphi$ between the normals of the target constituent surface and the adjacent constituent surface is less than a predetermined angle threshold $\varphi 0$ among the multiple constituent surfaces S that make up the acquired target surface data. The vehicle body controller 110 sets the target constituent surface and the adjacent constituent surface as different surface areas (for example, the surface area A1 including the constituent surface Sb shown in FIG. 11 and the surface area A2 including the constituent surface Sz adjacent to the constituent surface Sb) if the angle $\varphi$ between the normals of the target constituent surface and the adjacent constituent surface is equal to or greater than the angle threshold $\varphi 0$ among the multiple constituent surfaces S that make up the acquired target surface data.

According to this configuration, as shown in FIG. 11, when a flat surface or a gently curved surface is formed by multiple small constituent surfaces S, as shown in FIG. 12B, recording points can be set with an appropriate point density for the flat or curved surface.

(5) The vehicle body controller 110 sets recording points (black-filled triangle marks ▲ in FIG. 15A) on the outer perimeter of the surface area A. According to this configuration, the shape of the slope toe and slope shoulder in the slope areas 121 to 124 can be accurately represented.

(6) The vehicle body controller 110 sets recording points (black-filled star marks ★ in FIG. 15B) at the endpoints of the line (outer perimeter line Lo) that constitutes the outer perimeter of the surface area A. According to this configuration, the shape of the ends of the slope areas 121 to 124 (i.e., the corners of the target shape 120) can be accurately represented.

(7) The vehicle body controller 110 calculates the position information of the intersection of the line extending in the direction of the direction vector through the recording point and the trajectory of the working device 100a as construction history data. According to this configuration, the calculation load on the vehicle body controller 110 can be reduced compared to the case where the position (ENH coordinates) with the shortest distance from the recording point among the trajectory of the bucket 10 that passed within a certain range of area during a certain period is acquired as the trajectory information of the bucket 10.

(8) The vehicle body controller 110 calculates the direction vector associated with the recording point based on the normal vector of the surface area A to which the recording point belongs. According to this configuration, when the target surface St (surface area A) is set vertically with respect to the reference plane (E-N plane) (when the target shape 120 includes a vertical wall surface), or when the target surface St (surface area A) is set to protrude outward as it goes upward from the reference plane (when the target shape 120 includes an overhang shape), the construction history calculation system 181 can appropriately output the position information of the trajectory of the bucket 10.

(9) When the direction vector is a vertically upward vector, the calculation load on the vehicle body controller 110 can be reduced. Therefore, if the target shape 120 does not include a vertical wall surface and an overhang shape, the calculation load for the construction history data necessary for generating highly accurate terrain data can be reduced by uniformly setting the direction vector to a vertically upward vector.

(10) The vehicle body controller 110 calculates the distance (target surface distance) D from the recording point to the trajectory of the working device 100a in association with the recording point. The vehicle body controller 110 does not record the position information of the trajectory of the working device 100a associated with the recording point as construction history data if the calculated distance (target surface distance) D is equal to or greater than the distance threshold D0. The vehicle body controller 110 records the position information of the trajectory of the working device 100a associated with the recording point as construction history data if the calculated distance (target surface distance) D is less than the distance threshold D0. According to this configuration, it is possible to prevent duplicate position information from being generated for a given position of the trajectory of the bucket 10. In other words, the data capacity output from the construction history calculation system 181 to the terrain data calculation system 182 can be reduced.

The following variations are also within the scope of the present invention, and it is possible to combine the configurations shown in the variations with the configurations described in the above embodiments, or to combine the configurations described in the different variations below.

<Modification Example 1> In the above embodiment, an example was described in which recording points are set so that all the multiple surface areas A that make up the target surface data have the same point density, but the present invention is not limited to this. The vehicle body controller 110 may set recording points so that each surface area A has a different point density.

Generally, the parts that need to be closely checked to see if construction has been carried out as designed in as-built inspections, etc., are often the slope areas 121 to 124. Therefore, the recording point setting section 111 may set recording points so that the point density of the recording points in the slope areas 121 to 124 is greater than the point density of the recording points in the top surface area 125. In this case, the recording point setting section 111 sets the intervals of the recording points in the slope areas 121 to 124 shorter than the intervals of the recording points in the top surface area 125.

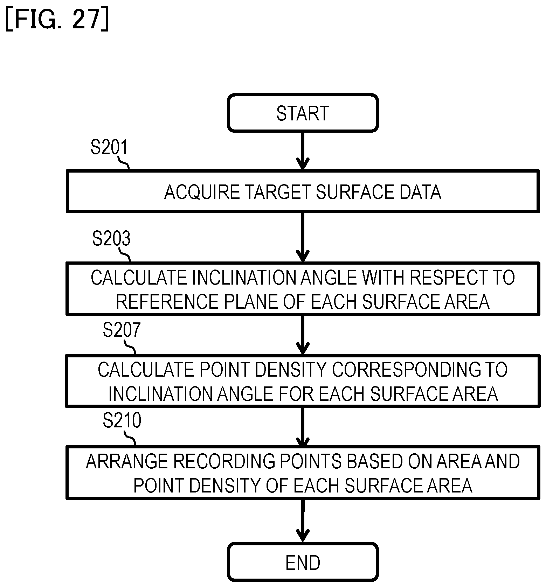

FIG. 27 describes the content of the recording point setting process executed by the vehicle body controller 110 according to Variation 1 of this embodiment. As shown in FIG. 27, in step S201, the vehicle body controller 110 acquires the target surface data and proceeds to step S203. In step S203, the vehicle body controller 110 calculates the inclination angle $\theta$ with respect to the reference plane (E-N plane) of each surface area A and proceeds to step S207. The inclination angle $\theta$ is 0° when parallel to the reference plane, increases as the tilt from the reference plane increases, and is 90° when perpendicular to the reference plane ($0° \leqq \theta \leqq 90°$).

In step S207, the vehicle body controller 110 calculates the point density corresponding to the inclination angle $\theta$ for each surface area A and stores it in RAM 110c in association with the surface area A. The point density corresponding to the inclination angle $\theta$ is calculated based on a table or formula that defines a relationship where the point density increases as the inclination angle $\theta$ increases. The table or formula that defines the relationship between the inclination angle $\theta$ and the point density is stored in advance in ROM 110b.

Once the calculation process for the point density for each surface area A (step S207) is completed, the process proceeds to step S210. In step S210, the vehicle body controller 110 arranges the recording points based on the area of the surface area and the point density set in association with the surface area A. In step S210, once the vehicle body controller 110 has finished arranging the recording points for all surface areas A, it ends the process shown in the flowchart of FIG. 27.

Thus, the vehicle body controller 110 according to this modification sets recording points so that the surface area A has a predetermined point density according to the inclination angle θ of the surface area A with respect to the reference plane (E-N plane) for each surface area A. As a result, the point density of the slope areas 121 to 124 becomes higher compared to the point density of the top surface area 125. As a result, the accuracy of the shape of the slope areas 121 to 124 can be increased compared to the top surface area 125.

Note that when the slope areas 121 to 124 and the top surface area 125 are each a single constituent surface S (see FIG. 9), the vehicle body controller 110 sets multiple constituent surfaces consisting of the top surface area (target constituent surface) 125 and the slope areas (adjacent constituent surfaces) 121 to 124 adjacent to the top surface area 125 (in the example shown in FIG. 9, five constituent surfaces) as a single surface area A. In this case, the vehicle body controller 110 sets multiple recording points so that the surface area A has a predetermined point density $\rho S$. Furthermore, the vehicle body controller 110 sets recording points so that each constituent surface S has a predetermined point density according to the inclination angle θ of the constituent surface S with respect to the reference plane.

<Modification Example 2> In the above embodiment, an example was described where adjacent constituent surfaces S are set as the same surface area A when the angle φ between the normals of adjacent constituent surfaces S is less than the angle threshold φ0. When a large number of constituent surfaces S are continuously set as the same surface area A, even if the angle φ between the normals of adjacent constituent surfaces S is small, the angle between the normals of the constituent surfaces at both ends of the same surface area A may become large. The recording points are arranged at equal intervals along the first and second reference axes parallel to one constituent surface S that constitutes the surface area A. Therefore, if the angle between the normals of the constituent surfaces S at both ends of one surface area A is large, there is a risk of variation in point density between the constituent surfaces S that make up one surface area A. Therefore, in this modification, when one surface area A is composed of multiple constituent surfaces S, the vehicle body controller 110 calculates the average vector Va of the normal vectors Vn of the multiple constituent surfaces S that make up one surface area A, and excludes the constituent surface S from one surface area A when the angle ψ between the average vector Va and the normal vector Vn of the constituent surface S is equal to or greater than the angle threshold ψ0. The angle threshold ψ0 is stored in advance in ROM 110b.

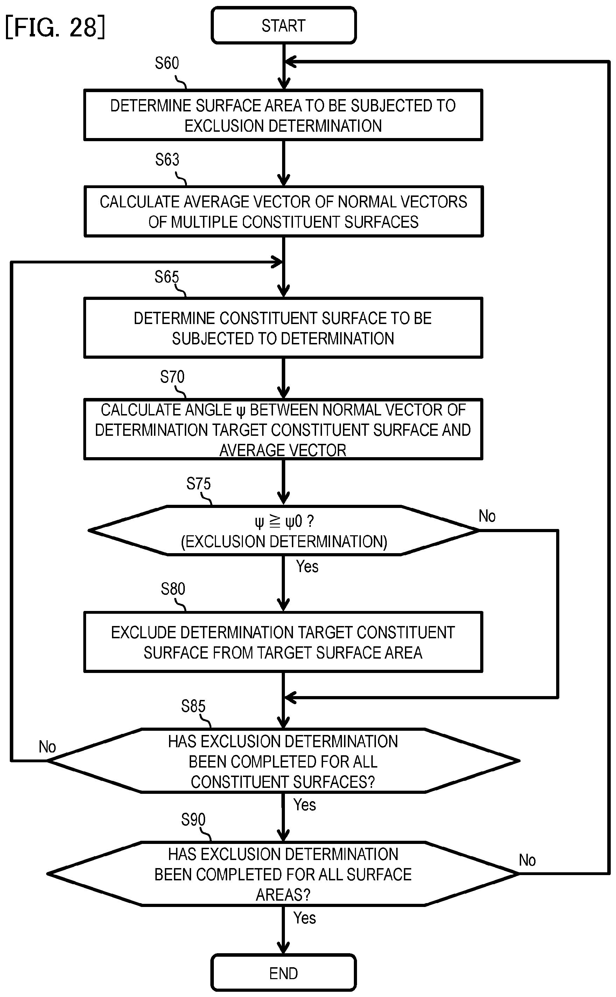

FIGS. 13 and 28 are diagrams explaining the flow of the surface area A setting process executed by the vehicle body controller 110 according to this modification. The vehicle body controller 110 executes the process of the flowchart shown in FIG. 13, and when the setting of the surface area A is completed for all constituent surfaces S (Yes in step S45), it executes the flowchart shown in FIG. 28. As shown in FIG. 28, in step S60, the vehicle body controller 110 determines one of the surface areas A composed of multiple constituent surfaces S among the multiple surface areas A as the surface area to be subjected to the exclusion determination (hereinafter also referred to as the target surface area) and proceeds to step S63.

In step S63, the vehicle body controller 110 calculates the average vector Va of the normal vectors Vn of the multiple constituent surfaces S that make up the target surface area and proceeds to step S65. In step S65, the vehicle body controller 110 determines the constituent surface to be subjected to the exclusion determination (hereinafter also referred to as the determination target constituent surface) among the multiple constituent surfaces S that make up the target surface area and proceeds to step S70.

In step S70, the vehicle body controller 110 calculates the angle ψ between the normal vector Vn of the determination target constituent surface and the average vector Va calculated in step S63 and proceeds to step S75.

In step S75, the vehicle body controller 110 determines whether the angle ψ calculated in step S70 is equal to or greater than the angle threshold ψ0. In step S75, if it is determined that the angle ψ is equal to or greater than the angle threshold $\phi0$, the process proceeds to step S80. In step S75, if it is determined that the angle ψ is less than the angle threshold ψ0, the process proceeds to step S85.

In step S80, the vehicle body controller 110 excludes the determination target constituent surface from the target surface area and proceeds to step S85. In step S85, the vehicle body controller 110 determines whether the exclusion determination process (step S75) has been completed for all constituent surfaces S in the target surface area. In step S85, if it is determined that the exclusion determination process has not been completed for all constituent surfaces S in the target surface area, the process proceeds to step S65. In step S65, the vehicle body controller 110 determines the constituent surface S to be subjected to the exclusion determination. Here, the vehicle body controller 110 determines a constituent surface S that has not been subjected to the exclusion determination even once as the determination target constituent surface.

In step S90, it is determined whether the exclusion determination has been completed for all surface areas A composed of multiple constituent surfaces S. In step S90, if it is determined that the exclusion determination has not been completed for all surface areas A composed of multiple constituent surfaces S, the process returns to step S60. In step S60, the vehicle body controller 110 sets the surface area A to be subjected to the exclusion determination. Note that the recording point setting section 111 determines a surface area A that has never been determined as a target surface area as the target surface area, without determining a surface area A that has once been determined as a target surface area as the target surface area.

In step S90, if it is determined that the exclusion determination has been completed for all surface areas A composed of multiple constituent surfaces S, the vehicle body controller 110 ends the process shown in the flowchart of FIG. 28.

According to this modification, when multiple constituent surfaces S are arranged continuously with a slight inclination, forming a target surface that curves gently over a long distance, it is possible to suppress the occurrence of differences in the angle between the normals of the constituent surfaces S at both ends of one surface area A. Therefore, it is possible to prevent variations in point density between the constituent surfaces S that make up one surface area A.

<Modification Example 3> In the above embodiment, an example was described where the distance threshold D0 is a constant value, but the present invention is not limited to this. The distance threshold D0 may be set according to the point density of the recording points or the distance between adjacent recording points, for example, or it may be set according to the target shape 120.

<Modification Example 3-1> The vehicle body controller 110 according to this modification calculates the distance threshold D0 for each recording point. The distance threshold D0 becomes smaller as the distance from a recording point to an adjacent recording point becomes shorter. The distance between adjacent recording points becomes shorter as the point density increases. Therefore, the distance threshold D0 becomes smaller as the point density of the recording points increases. Note that in this modification, as in Modification 1, the vehicle body controller 110 sets recording points so that the surface area A has a predetermined point density according to the inclination angle θ of the surface area A with respect to the reference plane (E-N plane) for each surface area A.

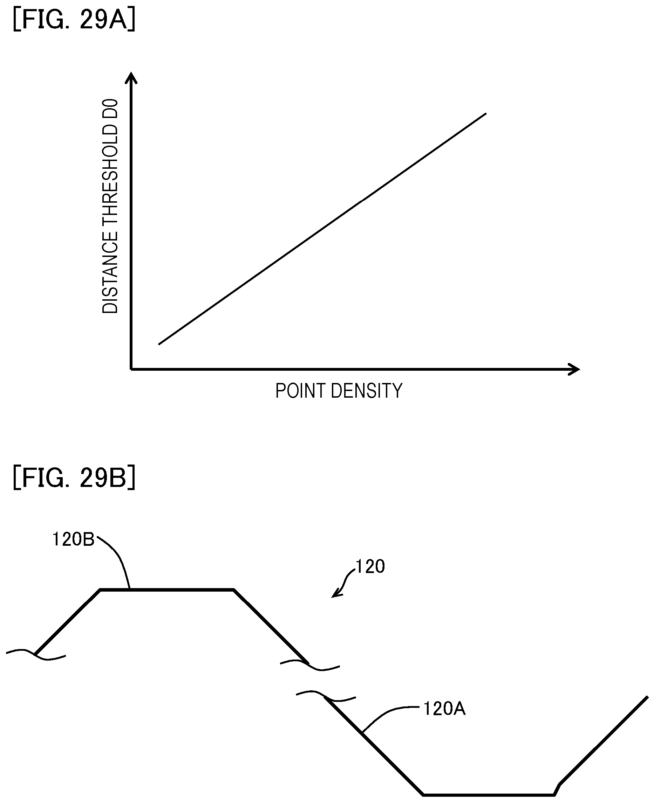

FIG. 29A is a diagram showing an example of a distance threshold table stored in ROM 110b. The distance threshold table shown in FIG. 29A has the horizontal axis representing point density and the vertical axis representing the distance threshold D0. The vehicle body controller 110 refers to the distance threshold table shown in FIG. 29A and calculates the distance threshold D0 based on the point density of the surface area A. As a result, for example, if the point density of the slope areas 121 to 124 is greater than the point density of the top surface area 125, the distance threshold D0 associated with the recording points of the slope areas 121 to 124 becomes smaller than the distance threshold D0 associated with the recording points of the top surface area 125.

Thus, the vehicle body controller 110 according to this modification calculates the distance threshold D0 for each recording point so that the distance threshold D0 associated with the recording points set in a high point density surface area A becomes smaller than the distance threshold D0 associated with the recording points set in a low point density surface area A. This allows for a reduction in the data volume of the position information of the trajectory of the bucket 10.

<Modification Example 3-2> FIG. 29B is a diagram showing the concave portion 120A and the convex portion 120B of the target shape 120. When the bucket 10 is hardly moving near the concave portion 120A of the target shape 120, the data volume of the position information of the trajectory of the bucket 10 tends to be larger compared to when the bucket 10 is hardly moving near the convex portion 120B. Therefore, the vehicle body controller 110 according to this modification calculates the distance threshold D0 for each recording point so that the distance threshold D0 associated with the recording points set in the concave portion 120A of the target shape 120 becomes smaller than the distance threshold D0 associated with the recording points set in the convex portion 120B of the target shape 120. This allows for the reduction of the data volume of the position information of the trajectory of the bucket 10.

<Modification Example 4> In the above embodiment, an example was described in which the construction history generation section 113 mainly calculates and records the trajectory coordinates of the bucket 10 using a method based on direction vectors, but the present invention is not limited to this. The construction history generation section 113 may calculate and record the trajectory coordinates of the bucket 10 without using direction vectors. For example, the construction history generation section 113 may record the coordinates of the point closest to the recording point among the trajectory of the bucket 10 that passed within a certain range of area (e.g., within a radius of 1m from the recording point) within a certain period (e.g., within 1 minute) as the position information of the trajectory of the bucket 10.

In this way, the vehicle body controller 110 according to this modification records the information of the position where the distance from the recording point in the trajectory of the working device 100a is shortest as the position information (trajectory coordinates) of the trajectory of the bucket 10. According to this configuration, it is possible to output construction history data necessary for generating more accurate terrain data. Furthermore, it is also possible to reduce the data volume of the position information of the trajectory of the bucket 10.

<Modification Example 5> An example was described using angle sensors 30, 31, 32 as posture sensors, but the present invention is not limited to this. Instead of angle sensors 30, 31, 32, stroke sensors that detect the cylinder lengths of the boom cylinder 5, arm cylinder 6, and bucket cylinder 7 may be employed as posture sensors. In this case, the posture detection device 130 calculates the boom angle α, arm angle β, and bucket angle γ based on the cylinder lengths detected by the stroke sensors.

<Modification Example 6> In the above embodiment, the vehicle body controller 110 provided in the hydraulic excavator 100 functions as a first processing device that executes a series of processes to generate construction history data based on the posture of the hydraulic excavator 100 detected by the posture detection device 130 and transmit the generated construction history data to an external management center 50 of the hydraulic excavator 100. The management controller 150 provided in the management center 50 functions as a second processing device that executes processing to generate terrain data based on the construction history data received from the vehicle body controller 110. However, the present invention is not limited to this. The vehicle body controller 110 of the hydraulic excavator 100 may be provided with the function of a second processing device.

<Modification Example 7> In the above embodiment, an example where the operating devices (22a, 22b, 23a, 23b) are electric operating devices was described, but the present invention is not limited to this. Instead of electric operating devices, hydraulic pilot-type operating devices may be employed.

<Modification Example 8> In the above embodiment, the case where the work machine is a crawler-mounted hydraulic excavator was described as an example, but the present invention is not limited to this. The work machine may be a wheel-type hydraulic excavator, bulldozer, wheel loader, etc.

<Modification Example 9> In the above embodiment, an example where the actuator includes hydraulic actuators such as a hydraulic motor and hydraulic cylinder was described, but the present invention may be applied to work machines equipped with electric actuators such as electric motors and electric cylinders.

While embodiments of the present invention have been described above, these embodiments are merely examples of the application of the present invention and are not intended to limit the technical scope of the present invention to the specific configurations of the above embodiments.

Description of Reference Characters

1...work machine management system, 16...target surface input device, 22a, 22b...operating device, 50...management center, 51...management server, 52...storage device, 53...display device, 54... input device, 55...communication device, 100...hydraulic excavator (work machine), 100a...working device, 100b...vehicle body (machine body), 110...vehicle body controller (controller), 111...record point setting section, 112...trajectory calculation section, 113...construction history generation section, 114...transmission section, 120...target shape, 120A...concave part, 120B... convex part, 121, 122, 123, 124...slope area, 125...top surface area 125, 125a, 125b, 125c, 125d...configuration surface, 130...posture detection device, 131...working device posture detection unit, 132...vehicle body position detection unit, 133...vehicle body angle detection unit, 141...first direction vector, 142...second direction vector, 150...management controller, 151...receiving section, 152...extraction section, 154...output section, 155...communication device, 158...valve drive device, 161...target surface input device, 162...pressure detection device, 163...operation detection device, 164...display device, 169...storage device, 180...terrain data generation system, 181...construction history calculation system, 182...terrain data calculation system, 190...progress management system, A...surface area A, D...target surface distance, D0...distance threshold, Dmin...shortest distance, La...configuration line, Lo...outer perimeter line, S...configuration surface

**Claims**

1.  A construction history calculation system comprising:

    a controller that calculates construction history data based on detection results of a posture detection device that detects a posture of a work machine, wherein
    the controller acquires target surface data and sets a plurality of configuration surfaces, including a target configuration surface that composes the target surface data and an adjacent configuration surface adjacent to the target configuration surface, in a surface area based on the acquired target surface data;
    the controller sets a plurality of recording points to achieve a predetermined point density for the surface area and calculates a trajectory of a working device of the work machine based on the detection results of the posture detection device;
    the controller calculates position information of the trajectory of the working device, which associates position information of monitor points of the working device that compose the trajectory of the working device with each of the plurality of recording points, as the construction history data.

2.  The construction history calculation system according to claim 1, wherein
    the controller sets the recording points to achieve a constant point density for all the configuration surfaces that constitute the target surface data.

3.  The construction history calculation system according to claim 1, wherein
    the controller sets the recording points to achieve a predetermined point density according to an inclination angle of the configuration surface relative to a reference plane for each configuration surface that constitutes the target surface data.

4. The construction history calculation system according to claim 1, wherein

the target surface data is data that defines a target shape by the plurality of configuration surfaces;
the controller sets the target configuration surface and the adjacent configuration surface as a same surface area if an angle formed by normals of the target configuration surface and the adjacent configuration surface is less than a predetermined angle threshold among the plurality of configuration surfaces that make up the acquired target surface data;
the controller sets the target configuration surface and the adjacent configuration surface as different surface areas if the angle formed by the normals of the target configuration surface and the adjacent configuration surface is equal to or greater than the angle threshold among the plurality of configuration surfaces that make up the acquired target surface data.

5. The construction history calculation system according to claim 4, wherein
the controller calculates an average vector of normal vectors of the plurality of configuration surfaces that constitute one surface area and excludes the configuration surface from the one surface area if an angle formed by the average vector and the normal vector of the configuration surface is equal to or greater than an angle threshold.

6. The construction history calculation system according to claim 1, wherein
the controller sets recording points on an outer periphery of the surface area.

7. The construction history calculation system according to claim 1, wherein
the controller sets the recording points at endpoints of lines that constitute an outer periphery of the surface area.

8. The construction history calculation system according to claim 1, wherein
the controller calculates position information of an intersection of a straight line extending in a direction of a direction vector passing through the recording point and the trajectory of the working device as the construction history data.

9. The construction history calculation system according to claim 8, wherein
the controller calculates the direction vector associated with the recording point based on a normal vector of the surface area to which the recording point belongs.

10. The construction history calculation system according to claim 8, wherein
the direction vector is a vector directed vertically upward.

11. The construction history calculation system according to claim 1, wherein

the controller calculates distance from the recording point to the trajectory of the working device in association with the recording point;
the controller does not record the position information of the trajectory of the working device associated with the recording point as the construction history data if the calculated distance is equal to or greater than a distance threshold, and records the position information of the trajectory of the working device associated with the recording point as the construction history data if the calculated distance is less than the distance threshold.

12. The construction history calculation system according to claim 11, wherein
the controller calculates the distance threshold for each recording point such that the distance threshold associated with a recording point set in a high point density area is smaller than the distance threshold associated with a recording point set in a low point density area.

13. The construction history calculation system according to claim 11, wherein
the controller calculates the distance threshold for each recording point such that the distance threshold associated with a recording point set in a concave part of a target shape is smaller than the distance threshold associated with a recording point set in a convex part of the target shape.

14. The construction history calculation system according to claim 1, wherein
the controller records information of a position where distance from the recording point to the trajectory of the working device is shortest as the position information of the trajectory of the working device.

15. A terrain data generation system including the construction history calculation system according to claim 1, the terrain data generation system comprising:

a terrain data calculation system that calculates terrain data indicating final shape by the working device of the work machine based on the position information of the trajectory of the working device included in the construction history data.

[FIG. 1]

[FIG. 2]

[FIG. 3]

EP 4 585 756 A1

## [FIG. 4]

```
110

COMMUNICATION
DEVICE                    ──►┐
130    155                   │
                             │
POSTURE                      │
DETECTION           ──►      │
DEVICE                       │
                             │      110a
TARGET SURFACE      ──►  I   │       CPU
INPUT DEVICE            N    │
169    161              P    │      O
                        U    │      U
STORAGE DEVICE ──►      T    │      T   ──►  COMMUNICATION DEVICE
                             │      P        155    181
PRESSURE            I        │      U
DETECTION      ──►  N        │      T   ──►  DISPLAY DEVICE  164
DEVICE              T        │      I
163    162          E        │      N
                    R  ROM RAM      T   ──►  VALVE DRIVE DEVICE  158
OPERATION      ──►  F  110b 110c    E
DETECTION           A               R
DEVICE              C  110d 110e    F
                    E               A
                                    C
                                    E
```

180

181

HYDRAULIC EXCAVATOR 100

MANAGEMENT CENTER 50

```
150

INPUT DEVICE  54   ──►  I    150a CPU   O   ──►  DISPLAY DEVICE 53
                       N              U
STORAGE DEVICE 52  ──►  P            T   ──►  STORAGE DEVICE 52
                       U              P
COMMUNICATION      ──►  T  ROM  RAM   U   ──►  COMMUNICATION
DEVICE 55                  150b 150c  T        DEVICE 55
                          150d 150e
```

182

[FIG. 5]

VEHICLE BODY CONTROLLER ~110

161 — TARGET SURFACE INPUT DEVICE

RECORDING POINT SETTING SECTION ~111

162 — PRESSURE DETECTION DEVICE

TRAJECTORY CALCULATION SECTION ~112

163 — OPERATION DETECTION DEVICE

CONSTRUCTION HISTORY GENERATION SECTION ~113

169 — STORAGE DEVICE

TRANSMISSION SECTION ~114

POSTURE DETECTION DEVICE ~130

131 — WORKING DEVICE POSTURE DETECTION UNIT

30
31
32

132 — VEHICLE BODY POSITION DETECTION UNIT

35a
36

133 — VEHICLE BODY ANGLE DETECTION UNIT

35b
33a
33b

181

180
182

MANAGEMENT CONTROLLER ~150

52 — STORAGE DEVICE

RECEIVING SECTION ~151

EXTRACTION SECTION ~152

OUTPUT SECTION ~154

190 — PROGRESS MANAGEMENT SYSTEM

EP 4 585 756 A1

[FIG. 6]

[FIG. 7]

[FIG. 8]

[FIG. 9]

RECORDING POINT     124(S)     120

121(S)     123(S)

125(S)

A     122(S)

[FIG. 10]

[FIG. 11]

[FIG. 12A]

S
S
S

RECORDING
POINT

[FIG. 12B]

S
S
S

RECORDING
POINT

A1(A)

[FIG. 13]

```
                              ┌──────────────┐
                              │    START     │
                              └──────┬───────┘
                                     │
  S10                                ▼
      ┌──────────────────────────────────────────────────────────┐
      │  DETERMINE CONSTITUENT SURFACE TO BE TARGET FOR           │
      │              SETTING SURFACE AREA                          │
      └──────────────────────────┬───────────────────────────────┘
                                  │
  S15                             ▼
      ┌──────────────────────────────────────────────────────────┐
      │  SELECT CONSTITUENT SURFACE ADJACENT TO TARGET            │
      │              CONSTITUENT SURFACE                           │
      └──────────────────────────┬───────────────────────────────┘
                                  │
  S20                             ▼
      ┌──────────────────────────────────────────────────────────┐
      │              CALCULATE NORMAL VECTORS                      │
      └──────────────────────────┬───────────────────────────────┘
                                  │
  S25                             ▼
      ┌──────────────────────────────────────────────────────────┐
      │  CALCULATE ANGLE φ BETWEEN NORMAL VECTOR OF               │
      │  TARGET CONSTITUENT SURFACE AND NORMAL VECTOR            │
      │  OF ADJACENT CONSTITUENT SURFACE                          │
      └──────────────────────────┬───────────────────────────────┘
                                  │
  S30                             ▼
```

S30: $\phi < \phi 0$ ? — No → S36: SET AS DIFFERENT SURFACE AREAS

Yes → S33: SET AS SAME SURFACE AREA

S40: ARE THERE OTHER CONSTITUENT SURFACES ADJACENT TO TARGET CONSTITUENT SURFACE FOR WHICH NO AREA HAS BEEN SET? — Yes (to S15)

No →

S45: HAS SETTING OF SURFACE AREA FOR ALL CONSTITUENT SURFACES BEEN COMPLETED? — No (to S10)

Yes →

END

[FIG. 14]

[FIG. 15A]

RECORDING POINT

[FIG. 15B]

RECORDING POINT

[FIG. 16]

START

S51
DETERMINE SURFACE AREA TO BE TARGET
FOR SETTING RECORDING POINTS

S53
ARRANGE RECORDING POINTS IN SURFACE AREA
AT POINT DENSITY ρS

S55
ARRANGE RECORDING POINTS ON OUTER PERIPHERY
OF SURFACE AREA AT LINE DENSITY ρL

S57
ARRANGE RECORDING POINTS AT ENDPOINTS
OF OUTER PERIPHERAL LINE OF SURFACE AREA

S59
HAS SETTING OF RECORDING POINTS
FOR ALL SURFACE AREAS BEEN
COMPLETED?

No

Yes

END

[FIG. 17]

TRAJECTORY OF BUCKET

FIRST DIRECTION
VECTOR 141
(VERTICAL VECTOR)

SECOND DIRECTION
VECTOR 142
(NORMAL VECTOR)

RECORDING
POINT Pr0

SHORTEST
DISTANCE Dmin

TRAJECTORY
OF BUCKET

TARGET
SURFACE St
(SURFACE
AREA A)

[FIG. 18]

120

BUCKET TRAJECTORY (1)

BUCKET TRAJECTORY (2)

BUCKET TRAJECTORY (3)

RECORDING POINT

RECORDING POINT

DIRECTION OF
CONSTRUCTION
PROGRESS

TARGET SURFACE St
（SURFACE AREA A）

[FIG. 19]

DIRECTION VECTOR

COMPOSITE VECTOR

DIRECTION VECTOR

TOP SURFACE AREA (SURFACE AREA A)

DIRECTION VECTOR OF TOP SURFACE AREA

120

DIRECTION VECTOR OF SLOPE AREA

CORNER RECORDING POINT Pc

Lo

Lo

DIRECTION VECTOR

SLOPE AREA (SURFACE AREA A)

[FIG. 20]

| TIME | RECORDING POINT COORDINATE (RECORDING POSITION) | | | TRAJECTORY COORDINATE (TRAJECTORY OF BUCKET) | | | OPERATION |
|---|---|---|---|---|---|---|---|
| | E | N | H | E | N | H | |
| 11:10:21 | 402.5 | 1125.5 | 312.214 | 402.5 | 1125.5 | 312.442 | EXCAVATION |
| 11:10:52 | 402.5 | 1125.5 | 312.214 | 402.5 | 1125.5 | 312.316 | EXCAVATION |
| 11:10:53 | 402.5 | 1125.0 | 312.218 | 402.5 | 1125.0 | 312.335 | EXCAVATION |
| 11:11:54 | 402.5 | 1125.5 | 312.214 | 402.5 | 1125.5 | 312.235 | EXCAVATION |
| 11:11:55 | 402.5 | 1125.0 | 312.218 | 402.5 | 1125.0 | 312.263 | EXCAVATION |
| 11:12:56 | 402.5 | 1125.5 | 312.214 | 402.5 | 1125.5 | 312.222 | EXCAVATION |

EP 4 585 756 A1

[FIG. 21]

GEOGRAPHICAL FEATURES

RECORDING POINT

10

DIRECTION OF PROGRESS

RECORDING POINT

DIRECTION VECTOR

RECORDING POINT

DIRECTION VECTOR

RECORDING POINT

TARGET SURFACE St
(SURFACE AREA A)

[FIG. 22]

| TIME | RECORDING POINT COORDINATE (RECORDING POSITION) | | | DIRECTION VECTOR | | | OPERATION | TARGET SURFACE DISTANCE |
|---|---|---|---|---|---|---|---|---|
| | E | N | H | E | N | H | | |
| 11:10:21 | 402.5 | 1125.5 | 312.214 | 0 | 0 | 1 | EXCAVATION | 0.228 |
| 11:10:52 | 402.5 | 1125.5 | 312.214 | 0 | 0 | 1 | EXCAVATION | 0.102 |
| 11:10:53 | 402.5 | 1125.0 | 312.218 | 0 | 0 | 1 | EXCAVATION | 0.117 |
| 11:11:54 | 402.5 | 1125.5 | 312.214 | 0 | 0 | 1 | EXCAVATION | 0.021 |
| 11:11:55 | 402.5 | 1125.0 | 312.218 | 0 | 0 | 1 | EXCAVATION | 0.045 |
| 11:12:56 | 402.5 | 1125.5 | 312.214 | 0 | 0 | 1 | EXCAVATION | 0.008 |

[FIG. 23]

```
                    ┌─────────────────┐
                    │      START      │
                    └─────────────────┘
                             │
                             │  S100
                             ▼
              ┌──────────────────────────────┐
              │  SET RECORDING POINTS AND     │
              │      DIRECTION VECTORS        │
              └──────────────────────────────┘
                             │
                             │  S105
                             ▼
              ┌──────────────────────────────┐
              │  ACQUIRE SENSOR INFORMATION   │
              └──────────────────────────────┘
                             │
                             │  S110
                             ▼
         No  ╱──────────────────────────────╲
      ◄──────   IS WORK BY WORKING DEVICE
             ╲    BEING PERFORMED?           ╱
              ╲──────────────────────────────╱
                             │ Yes
                             │  S120
                             ▼
              ┌──────────────────────────────┐
              │  CALCULATE TRAJECTORY OF BUCKET│
              └──────────────────────────────┘
                             │
                             │  S125
                             ▼
    ┌──────────────────────────────────────────────────────────┐
    │  CALCULATE TRAJECTORY COORDINATES CORRESPONDING TO         │
    │  RECORDING POINTS AND TARGET SURFACE DISTANCE              │
    └──────────────────────────────────────────────────────────┘
                             │
                             │  S130
                             ▼
         No  ╱──────────────────────────────╲
      ◄──────   HAS BUCKET PASSED NEAR
             ╲    RECORDING POINT?           ╱
              ╲──────────────────────────────╱
                             │ Yes
                             │  S140
                             ▼
              ┌──────────────────────────────┐
              │  RECORD CONSTRUCTION          │
              │  HISTORY DATA                 │
              └──────────────────────────────┘
```

[FIG. 24]

```
                                    ┌─────────┐
                                    │  START  │
                                    └────┬────┘
                                         │
                                         ▼
              No              ◇ IS THERE      ◇
        ┌───────────────────── EMBANKMENT? ───
        │                         │
        │                        Yes
        ▼                         ▼
┌──────────────────────┐  ┌──────────────────────┐
│ TARGET SURFACE       │  │ TIME IS LATEST VALUE  │
│ DISTANCE IS          │  │                       │
│ MINIMUM VALUE        │  │                       │
└──────────────────────┘  └──────────────────────┘
```

[FIG. 25]

```
        ┌──────────┐
        │  START   │
        └────┬─────┘
             ↓
S150  ┌──────────────────────┐
      │   EXTRACT LOG DATA    │
      └──────────┬───────────┘
                 ↓
S170  ┌──────────────────────┐
      │  OUTPUT TERRAIN DATA  │
      └──────────┬───────────┘
                 ↓
        ┌──────────┐
        │   END    │
        └──────────┘
```

[FIG. 26A]

[FIG. 26B]

[FIG. 27]

START

S201

ACQUIRE TARGET SURFACE DATA

S203

CALCULATE INCLINATION ANGLE WITH RESPECT TO
REFERENCE PLANE OF EACH SURFACE AREA

S207

CALCULATE POINT DENSITY CORRESPONDING TO
INCLINATION ANGLE FOR EACH SURFACE AREA

S210

ARRANGE RECORDING POINTS BASED ON AREA AND
POINT DENSITY OF EACH SURFACE AREA

END

[FIG. 28]

START

S60
DETERMINE SURFACE AREA TO BE SUBJECTED TO EXCLUSION DETERMINATION

S63
CALCULATE AVERAGE VECTOR OF NORMAL VECTORS OF MULTIPLE CONSTITUENT SURFACES

S65
DETERMINE CONSTITUENT SURFACE TO BE SUBJECTED TO DETERMINATION

S70
CALCULATE ANGLE ψ BETWEEN NORMAL VECTOR OF DETERMINATION TARGET CONSTITUENT SURFACE AND AVERAGE VECTOR

S75
$\psi \geqq \psi 0$ ?
(EXCLUSION DETERMINATION) — No

Yes

S80
EXCLUDE DETERMINATION TARGET CONSTITUENT SURFACE FROM TARGET SURFACE AREA

S85
No — HAS EXCLUSION DETERMINATION BEEN COMPLETED FOR ALL CONSTITUENT SURFACES?

Yes

S90
HAS EXCLUSION DETERMINATION BEEN COMPLETED FOR ALL SURFACE AREAS? — No

Yes

END

[FIG. 29A]

[FIG. 29B]

## INTERNATIONAL SEARCH REPORT

| International application No. |
| --- |
| **PCT/JP2023/028819** |

### A. CLASSIFICATION OF SUBJECT MATTER

***E02F 9/26***(2006.01)i; ***E02F 3/43***(2006.01)i
FI:  E02F9/26 B; E02F3/43 A

According to International Patent Classification (IPC) or to both national classification and IPC

### B. FIELDS SEARCHED

Minimum documentation searched (classification system followed by classification symbols)

E02F9/26; E02F3/43

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2019-049121 A (KOMATSU MFG CO LTD) 28 March 2019 (2019-03-28)<br>entire text, all drawings | 1-15 |
| A | JP 2015-055109 A (HITACHI CONSTRUCTION MACHINERY) 23 March 2015 (2015-03-23)<br>column "3rd embodiments", etc. | 1-15 |
| A | WO 2022/107718 A1 (HITACHI CONSTRUCTION MACHINERY) 27 May 2022 (2022-05-27)<br>entire text, all drawings | 1-15 |
| A | JP 2022-030484 A (KOMATSU MFG CO LTD) 18 February 2022 (2022-02-18)<br>entire text, all drawings | 1-15 |
| A | JP 2020-117982 A (HITACHI CONSTRUCTION MACHINERY) 06 August 2020 (2020-08-06)<br>entire text, all drawings | 1-15 |

☑ Further documents are listed in the continuation of Box C.       ☑ See patent family annex.

| | |
| --- | --- |
| * Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **15 September 2023** | **26 September 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/028819**

### C. DOCUMENTS CONSIDERED TO BE RELEVANT

| Category* | Citation of document, with indication, where appropriate, of the relevant passages | Relevant to claim No. |
|---|---|---|
| A | JP 2017-179961 A (HITACHI CONSTRUCTION MACHINERY) 05 October 2017 (2017-10-05)<br>entire text, all drawings | 1-15 |

Form PCT/ISA/210 (second sheet) (January 2015)

## INTERNATIONAL SEARCH REPORT
### Information on patent family members

International application No.

**PCT/JP2023/028819**

| Patent document cited in search report | | | Publication date (day/month/year) | Patent family member(s) | | | Publication date (day/month/year) |
|---|---|---|---|---|---|---|---|
| JP | 2019-049121 | A | 28 March 2019 | US | 2020/0388043 | A1 | |
| | | | | WO | 2019/049475 | A1 | |
| | | | | DE | 112018001834 | T5 | |
| | | | | CN | 110573834 | A | |
| | | | | AU | 2018327449 | A1 | |
| JP | 2015-055109 | A | 23 March 2015 | US | 2016/0002882 | A1 | |
| | | | | column "embodiment 3", etc. | | | |
| | | | | WO | 2015/037642 | A1 | |
| | | | | EP | 3045589 | A1 | |
| | | | | CN | 105008622 | A | |
| WO | 2022/107718 | A1 | 27 May 2022 | (Family: none) | | | |
| JP | 2022-030484 | A | 18 February 2022 | WO | 2022/030289 | A1 | |
| | | | | DE | 112021002794 | T5 | |
| | | | | KR | 10-2023-0014088 | A | |
| | | | | CN | 115777036 | A | |
| | | | | US | 2023/243127 | A1 | |
| JP | 2020-117982 | A | 06 August 2020 | (Family: none) | | | |
| JP | 2017-179961 | A | 05 October 2017 | US | 2017/0284057 | A1 | |
| | | | | EP | 3235961 | A1 | |
| | | | | CN | 107268699 | A | |
| | | | | KR | 10-2017-0113046 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005011058 A